## Europäisches Patentamt

## European Patent Office

## Office européen des brevets

(11) Veröffentlichungsnummer: **0 128 228**
**B1**

(12) **EUROPÄISCHE PATENTSCHRIFT**

(45) Veröffentlichungstag der Patentschrift:
07.01.88

(51) Int. Cl.⁴: **H 03 K 3/78**

(21) Anmeldenummer: 83105616.3

(22) Anmeldetag: 08.06.83

(54) Verfahren und Anordnung zur Erzeugung von Impulsen beliebiger Zeitrelation innerhalb unmittelbar aufeinanderfolgender Impulsintervalle mit sehr hoher Genauigkeit und zeitlicher Auflösung.

(43) Veröffentlichungstag der Anmeldung:
19.12.84 Patentblatt 84/51

(45) Bekanntmachung des Hinweises auf die Patenterteilung:
07.01.88 Patentblatt 88/1

(84) Benannte Vertragsstaaten:
DE FR GB

(56) Entgegenhaltungen:
DE - A - 2 746 743
DE - A - 2 829 709
DE - A - 2 854 980
DE - A - 2 917 017
DE - A - 2 936 250
DE - A - 3 023 699
US - A - 4 165 490
US - A - 4 287 594

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Staiger, Dieter Ernst, IBM Burlington Dept. B33, Bldg. 617-2, Essex Junction Vermont 05452 (US)**

(74) Vertreter: **Blutke, Klaus, Dipl.-Ing., Schönaicher Strasse 220, D-7030 Böblingen (DE)**

## Beschreibung

Die Erfindung betrifft ein Verfahren und eine Anordnung zur Erzeugung von Impulsen vorgegebener Zeitrelation innerhalb vorgegebener Impulsintervalle mit sehr hoher zeitlicher Auflösung.

Impulsfolgen dieser Art sind insbesondere zum Austesten von Halbleiter-Speicherprodukten (Digitale Speicheranordnungen mit zugehörigen Pufferspeichern), von Digitalschaltungen u.a. mehr erforderlich.

Bisher waren der zeitlichen Auflösung solcher Impulsfolgen durch die verfügbaren Schaltungen zu ihrer Erzeugung und verfügbare Schaltkreistechnologie und der damit verbundenen Schnelligkeit der Schaltkreise Grenzen gesetzt.

Beim Austesten von derartigen Speicherprodukten wird diesen ein entsprechendes Impulsmuster zugeführt. Das Verhalten des Speicherproduktes hinsichtlich dieses Impulsmusters wird aufgezeichnet und mit theoretischen Wunschwerten verglichen. Der Vergleich beider Werte ermöglicht eine Aussage, ob das Speicherprodukt wie gewünscht arbeitet oder ob an bestimmten Stellen Fehler vorliegen.

Die zu erzeugende Impulsfolge ist zunächst theoretisch durch die Spezifikationen des Speicherproduktes vorgegeben. Ausgehend von diesen theoretischen Werten muss die Impulsfolge dann praktisch von einem entsprechenden Impulsgenerator erzeugt werden.

Zur näheren Erklärung sei bemerkt, dass für ein möglichst optimales Austesten auch der Fall zu berücksichtigen ist, dass bei einem von der Produktseite her bestimmten Ereignis eine Impulsfolge von einer anderen abgelöst werden muss. D.h., die ursprüngliche Impulsfolge ist durch eine neue Impulsfolge beim Auftreten eines solchen Ereignisses zu ersetzen. Das Umschalten von einer Impulsfolge auf eine andere erforderte bei herkömmlichen Hardware-Testeinrichtungen eine bestimmte Zeit. Ein nahtloses Umschalten war aus technischen Gründen bei diesen Hardware-Testeinrichtungen nicht möglich, da das Umschalten auf eine neue Impulsfolge erst zu einer Zeit erfolgen konnte, wenn aufgetretene Umschalt-Einschwingvorgänge abgeklungen waren. Durch die dadurch bedingte Wartezeit musste jedoch der Nachteil in Kauf genommen werden, dass sich während dieser Wartezeit andere Konditionen im auszutestenden Produkt einstellen konnten. Aus diesem Grunde wurde seitens der Anmelderin bereits in der DE-A1-2 746 743 ein Verfahren und eine Anordnung zur Erzeugung zeitlich unmittelbar aufeinanderfolgender Impulsfolgen vorgeschlagen, welches dadurch gekennzeichnet war, dass von einem zähltaktgetriebenen von einem Speicher mit einem Ausgangszählwert ladbaren Abwärtszähler bei Erreichung eines bestimmten Zählerstandes die Impulserzeugung abgeleitet wird, dass vor Erreichung dieses bestimmten Zählerstandes das Laden des Abwärtszählers mit einem neuen Zählerausgangswert aus dem Speicher eingeleitet und zu einem Zeitpunkt vollzogen wird, an dem der Abwärtszähler für den vorausgehenden Zählvorgang den Zählerstand Null erreicht hätte, so dass die Abwärtszählvorgänge zeitlich unmittelbar aufeinanderfolgen und somit auch der zeitliche Abstand der von den Abwärtszählvorgängen abgeleiteten Impulsen von den durch den Speicher zur Verfügung zu stellenden Zählerausgangswerten gesteuert wird.

Unter Zugrundelegung eines eine Anordnung zur Durchführung dieses Verfahrens treibenden 100-MHz-Oszillators mit einem 10-Nanosekunden-Zeitraster (eine höhere Frequenz des Oszillators liesse die Schnelligkeit der verfügbaren Schaltkreise nicht zu) liessen sich Impulse vorgegebener Zeitrelation (mit einem 1-Nanosekunden-Zeitraster) innerhalb vorgegebener Impulsintervalle mit einem 10-Nanosekunden-Zeitraster erzeugen. Eine derartige 10-Nanosekunden-Zeitrasterung war jedoch insbesondere für das Austesten schneller Speicherprodukte unzureichend.

Aus diesem Grunde wurde von der Anmelderin in der DE-A-2 829 709 ein Verfahren zur Erzeugung zeitlich unmittelbar aufeinanderfolgender Impulszyklen vorgeschlagen, bei dem von einem zähltaktgetriebenen und von einem Speicher mit einem Ausgangszählwert ladbaren Abwärtszähler bei Erreichung eines bestimmten Zählerstandes die Erzeugung des Impulszyklus abgeleitet wird und bei dem vor Erreichung dieses bestimmten Zählerstandes das Laden des Abwärtszählers mit einem neuen Zählerausgangswert aus dem Speicher eingeleitet und zu einem Zeitpunkt vollzogen wird, an dem der Abwärtszähler für den vorausgehenden Zählvorgang den Zählerstand Null erreicht hätte. Dieses Verfahren war dadurch gekennzeichnet, dass der Beginn eines Abwärtszählvorganges des Abwärtszählers um ganzzahlige Vielfache des Zähltaktes verzögert wird, und dass ein bei Erreichung eines bestimmten Zählerstandes des Abwärtszählers abgeleiteter Impuls I einer Verzögerung hoher zeitlicher Auflösung zur Vorgabe eines Zyklusbeginnimpulses unterworfen wird.

Nach der in dieser Offenlegungsschrift beschriebenen Anordnung ist es möglich, auch Impulsintervalle im 1-Nanosekunden-Zeitraster vorzusehen. Jedoch musste (schaltungsbedingt) der Beginn eines neuen Impulsintervalles immer mit dem Beginn eines von einem Quarzoszillator abgeleiteten 10-Nanosekunden-Zeitrasters übereinstimmen. Aus diesem Grunde waren bei dieser Anordnung sogenannte «Totzeiten» von ca. 20 ns in Kauf zu nehmen, die sich entweder vor Beginn eines neu zu erzeugenden Pulses oder nach Abklingen eines bereits erzeugten Impulses bis zum Beginn des folgenden Impulsintervalles ergaben.

Der Grund hierfür lag darin, dass die 1-Nanosekunden-Verzögerungswerte für die zu erzeugenden Impulse in entsprechende Zähler zu laden waren, und dass diese Ladevorgänge nur zu Zeiten durchgeführt werden konnten, während der keine Impulserzeugung ablief bzw. während der eine erzeugte Impuls bereits abgeklungen war.

Somit war es nicht möglich, Impulsintervalle mit einer zeitlichen Auflösung im 1-Nanosekunden-Zeitraster unmittelbar aufeinander folgen zu lassen.

Aus diesem Grunde wurde in der DE-A-3 023 699 zur Vermeidung solcher Totzeiten ein Verfahren angegeben, das es möglich macht, Impulsintervalle hoher zeitlicher Auflösung mit Impulsen ebenfalls hoher zeitlicher Auflösung unmittelbar (ohne Totzeit) aufeinander folgen zu lassen. Die zeitliche Auflösung für die Impulsintervalle und die Impulse liegt bei diesem Verfahren bei einer Nanosekunde (unter Zugrundelegung der verfügbaren Schaltkreistechnologie und der damit verbundenen Schnelligkeit der Schaltkreise). Hierbei werden die Anfang (IIN1A, IIN2A) und Ende (IIN1E, IIN2E) eines Impulsintervalles kennzeichnenden Signale speichergesteuert von einem Oszillator zur Vorgabe zeitlicher Grobrasterwerte und einer dem Oszillator nachgeschalteten Verzögerungsschaltung mit selektiv auswählbaren Verzögerungsschaltungsabgriffen für zeitliche Feinrasterwerte gebildet. Die die Impulsintervalle kennzeichnenden Signale werden alternierend jeweils einem von zwei Wegen (Weg I, Weg II) in einer Weise zugeführt, dass das den jeweiligen Impulsintervallanfang kennzeichnende Signal mit dem durch den Oszillator vorgegebenen zeitlichen Grobraster übereinstimmt. Für jeden Weg wird die Anstiegs- und Abfallflanke eines innerhalb eines Impulsintervalles zu bildenden Impulses über oszillatortaktgetriebene und von einem Speicher mit einem Zählwert ladbare Zähler bei der Erreichung eines bestimmten Zählerstandes abgeleitet. Den Zählern für die Bildung der Anstiegs- bzw. Abfallflanke ist jeweils eine gemeinsame Verzögerungsschaltung mit speichergesteuert, selektiv auswählbaren Verzögerungsschaltungsabgriffen bzw. für ein zeitliches Feinraster nachgeschaltet. Die auf beiden Wegen erzeugte Impulsinformation wird auf einer gemeinsamen Leitung zusammengeführt.

Die in DE-A-3 023 699 gezeigte Schaltung ermöglicht die Darstellung von Impulsintervallen mit einer Auflösung im 1-Nanosekunden-Zeitraster. Die innerhalb solcher Impulsintervalle zu plazierenden Impulse weisen ebenfalls eine Auflösung im 1-Nanosekunden-Zeitraster auf. Von dem in der Schaltung verwendeten 100-MHz-Quarzoszillator wurde ein 10-Nanosekunden-Zeitraster abgeleitet. Auf dieses 10-Nanosekunden-Zeitraster ist das 1-Nanosekunden-Zeitraster der Impulsintervalle zurückzuführen. Die Oszillatorfrequenz von 100 MHz (10-Nanosekunden-Zeitraster) wird im folgenden Basisfrequenz genannt, einer Verzögerungsleitung mit um 1 ns gestaffelten Abgriffen zugeführt. Im Falle eines 33-Nanosekunden währenden Impulsintervalles muss über die 10-Nanosekunden-Zeitrasterung hinaus (3 Grob-Zeitraster) der entsprechende, insgesamt 3 Nanosekunden ausmachende Abgriff der Verzögerungsleitung V angesteuert werden.

Von diesem Abgriff der Verzögerungsleitung wird die Basisfrequenz einer Zeitgabeschaltung zur Plazierung der Impulse innerhalb des Impulsintervalles zugeleitet.

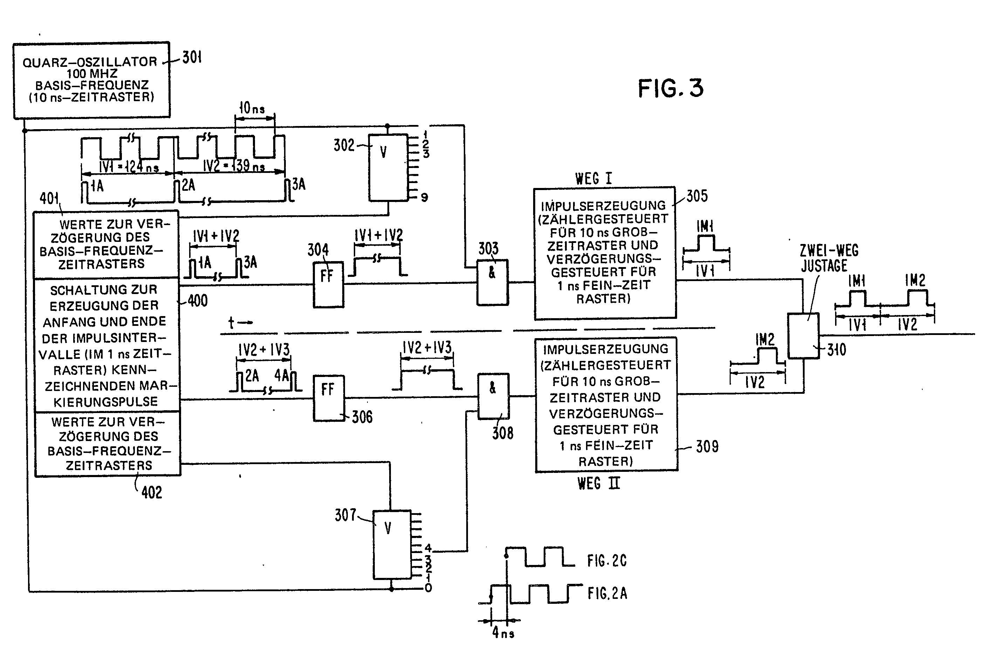

Das Umschalten auf einen anderen Abgriff der Verzögerungsleitung V ist mit entsprechenden Wartezeiten verbunden, auf die später noch in Zusammenhang mit Fig. 3 näher eingegangen wird.

Solche Wartezeiten würden jedoch eine Erzeugung zeitlich unmittelbar aufeinanderfolgender Impulsintervalle verhindern. Aus diesem Grunde wurde in der DE-A-3 023 699 ein «Zwei-Weg-Verfahren» gewählt, bei dem alternierend auf Weg I und Weg II die einzelnen Impulsintervalle mit den in ihnen auftretenden Impulsen erzeugt und schliesslich auf eine Leitung zusammengeführt werden.

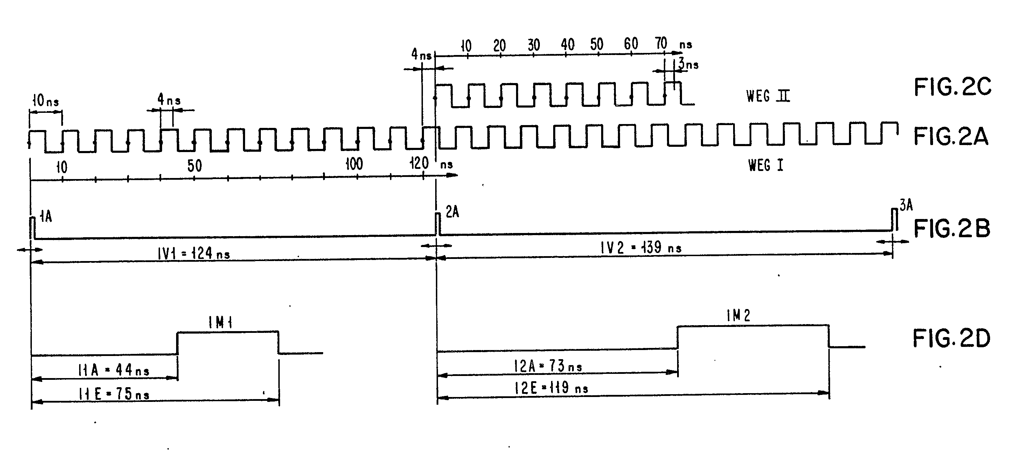

In den Fig. 2A–2D sind in zeitlicher Relation zueinander ein 10-Nanosekundenimpulsraster, Impulsintervalle und innerhalb der Impulsintervalle auftretende Impulse, beide im 1-Nanosekunden-Zeitraster, gezeigt.

Diese Darstellung dient (in Zusammenhang mit Fig. 3) einer zusammenfassenden Verdeutlichung des in der DE-A-3 023 699 beschriebenen Verfahrens zur totzeitlose Erzeugung von aufeinanderfolgenden Impulsintervallen mit darin auftretenden Impulsen. Im vorgegebenen Ausführungsbeispiel liegt die zeitliche Auflösung der Impulsintervalle und Impulse bei einer Nanosekunde. Der Erzeugung der Impulsintervalle liegt ein 10-Nanosekunden-Zeitraster eines 100-MHz-Quarzoszillators zugrunde.

Der Verlauf eines solchen von einem 100-MHz-Oszillator abgeleiteten 10-Nanosekunden-Zeitrasters ist in Fig. 2A gezeigt. Dieses Zeitraster wird einem Weg I zugeordnet. Impulsintervalle werden – wie beispielsweise in Fig. 2B dargestellt – mit einer zeitlichen Dauer von IV1 = 124 Nanosekunden und mit einer zeitlichen Dauer von IV2 = 139 Nanosekunden vorgegeben. Der Beginn bzw. das Ende jedes Impulsintervalles wird durch Markierungsimpulse 1A, 2A, 3A gekennzeichnet. Die Impulsintervalle folgen totzeitlos aufeinander, so dass das das Ende eines Impulsintervalles kennzeichnende Markierungssignal zugleich den Beginn des nachfolgenden Impulsintervalles kennzeichnet. In Fig. 2D ist gezeigt, wie innerhalb der einzelnen Impulsintervalle IV1 und IV2 Impulse IM1 und IM2 vorgegeben werden mit einem Zeitbezug auf den den Beginn des entsprechenden Impulsintervalles kennzeichnenden Markierungspuls. Im ersten Impulsintervall IV1 erscheint der Impuls I1, dessen Anstiegsflanke von dem Beginn des Impulsintervalles IV1 I1A = 44 Nanosekunden entfernt ist.

Zur Festlegung der Anstiegsflanke von IM1 werden vier aufeinanderfolgende 10-Nanosekunden-Zeitraster (4×10 Nanosekunden = 40 Nanosekunden) zählergesteuert vorgegeben; anschliessend erfolgt mit Hilfe einer Verzögerungsleitung eine Verzögerung um 4 Nanosekunden (44–40 = 4). Auf diese Weise bleibt die Erzeugung der Impulsflanke durch Rückführung auf das 10-Nanosekunden-Zeitrastermass des 100-MHz-Quarzoszillators «quarzgenau». Die einzige in Kauf zu nehmende Ungenauigkeit bezieht sich auf die Toleranz der um 1 Nanosekunde gestaffelten Abgriffe der Verzögerungsleitung.

Die Festlegung der Abfallflanke des Impulses IM1 erfolgt analog. Um die zählergesteuert und durch Verzögerung erfolgende Festlegung der Impulsflanken, auch für IM2 beibehalten zu können, ist jedoch sicherzustellen, dass der Beginn des Markierungsimpulses 2A mit dem Beginn eines 10-Nanosekunden-Zeitrasters übereinstimmt. (Bei IV1 = 124 Nanosekunden ist dies natürlich nicht der Fall). Aus diesem Grunde wird das 10-Nanosekunden-Zeitraster gemäss Fig. 2A um 4 Nanosekunden zeitverschoben und einem Weg II zugeordnet. Auf diese Weise ist sichergestellt, dass die Festlegung der Impulsanstiegsflanke (I2A = 72 ns) von IM2 zählergesteuert (Vorgabe von 7×10-Nanosekunden-Zeitraster zuzüglich einer Verzögerung um 3 Nanosekunden) erfolgen kann.

Es wäre denkbar, sich die Festlegung der Impulsflanken nur von einer entsprechenden Impulsverzögerung abzuleiten. Abgesehen von dem dafür erforderlichen Schaltungsaufwand würde jedoch eine solche Lösung bedingen, dass sich Ungenauigkeiten hinsichtlich des zeitlichen Auftretens der Markierungsimpulse 1A bzw. 2B (in Fig. 2B durch einen Doppelpfeil gekennzeichnet), durch das gesamte System fortpflanzten. Die Zeitrelationen der Impulse und Impulsintervalle zueinander wäre dadurch fortlaufend in einer für entsprechende Anwendungen unvertretbaren Weise gestört.

Deshalb wurde gemäss der DE-A-3 023 699 die Erzeugung der Impulsflanken der Impulse IM1 und IM2 «quarzgenau synchronisiert», wonach eine quarzgenaue, zählergesteuerte Festlegung der Impulsflanken für die Impulse innerhalb einzelner Impulsintervalle möglich ist.

In Fig. 3 ist eine Schaltung zur Durchführung des nach der DE-A-3 023 699 bekannten Verfahrens (Fig. 2) gezeigt. Der 100-MHz-Oszillator 301 arbeitet sowohl auf einen mit Weg I als auch auf einen mit Weg II gekennzeichneten Schaltungsteil. Die Zeitangaben in dieser Darstellung verstehen sich wiederum nur als Beispiel und nehmen Bezug auf die in Fig. 2 vorgegebenen Zeitverhältnisse der Impulsintervalle IV1, IV2 und der Impulse IM1, IM2. Die Erzeugung der einzelnen Impulsintervalle folgt alternierend auf den Wegen I und II. Angenommen, das Impulsintervall IV1 würde auf dem Weg I erzeugt werden. Aus Vereinfachungsgründen soll der Markierungsimpuls 1A als Beginn des Impulsintervalles IV1 mit dem Beginn eines 10-Nanosekunden-Zeitrasters übereinstimmen. Aus diesem Grunde soll auch dieses Zeitraster durch die Verzögerungsleitung 302 mit um 1 Nanosekunde gestaffelten Abgriffen (1 bis 9) keine Verzögerung erfahren. Die 10-ns-Zeitrasterfolge wird einem UND-Glied 303 zugeleitet, dessen zweiter Eingang so lange konditioniert ist, wie die Dauer (124+139 Nanosekunden) für das Impulsintervall IV1+IV2 anhält. Eine Schaltung 400 dient der Erzeugung der Anfang und Ende der Impulsintervalle kennzeichnenden Markierungsimpulse (1A, 2A, 3A etc.) im 1-Nanosekunden-Zeitraster. Die Impulsintervalle werden alternierend auf den Wegen I und II generiert. Durch eine Flipflop-Schaltung 304 (Weg I) bzw. 306 (Weg II) wird aus aufeinanderfolgenden Markierungsimpulsen ein Signal erzeugt, dessen Dauer auf dem Weg I IV1+IV2 und auf dem Weg II IV2+IV3 entspricht. Mit diesem für die Zeitdauer des Impulsintervalles IV1+IV2 (Weg I) anhaltenden Signales wird die UND-Schaltung 303 beaufschlagt. Auf diese Weise wird für diese Zeitdauer die UND-Schaltung 303 konditioniert, entsprechend viele 10-ns-Zeitraster hindurchzulassen. In der dem UND-Glied 303 nachgeschalteten Schaltung 305 zur Impulserzeugung, (die wie bereits erwähnt zählergesteuert für das 10-Nanosekunden-Grob-Zeitraster und verzögerungsleitungsgesteuert für das 1-Nanosekunden-Fein-Zeitraster arbeitet) erfolgt dann die Generierung des Impulses IM1 innerhalb des Impulsintervalles IV1. Da von vornherein bekannt ist, dass die Impulsanstiegsflanke von IM1 44 Nanosekunden nach dem Auftreten von 1A zu bilden ist, braucht von der Schaltung 305, (die ausführlich in DE-A-3 023 699 beschrieben), nur noch ein zählergesteuerter Vergleich für 4 10-Nanosekunden-Zeitraster eine Verzögerung von 4 Nanosekunden durchgeführt zu werden. Entsprechend wird auch das Impulsende von IM1 zähler- und verzögerungsleitungsgesteuert festgelegt.

In Zusammenhang mit Fig. 2 wurde bereits darauf hingewiesen, dass das 10-Nanosekunden-Zeitraster für den Weg II um beispielsweise 4 Nanosekunden zu verzögern ist. Dieser Wert, der sich als Differenzwert der Dauer des Impulsintervalles im 1-Nanosekunden-Zeitraster zu ganzzahligen Vielfachen des 10-Nanosekunden-Zeitrasters darstellt, ist vor der Erzeugung des Impulsmusters bekannt. Differenzwerte dieser Art für die einzelnen Impulsintervalle, die alternierend auf den Wegen I oder II generiert werden, können somit in Registern 401 bzw. 402 gespeichert und zur entsprechenden Ansteuerung der Verzögerungsleitung 303 bzw. 307 (für Weg II) verwendet werden.

Im Falle des Impulsintervalles IV2 (Weg II) beträgt dieser Wert wie bereits erwähnt 4 Nanosekunden. Durch diesen Steuerwert wird der entsprechende Verzögerungsleitungsabgriff der Verzögerungsleitung 307 aktiviert, so dass sich für das 10-Nanosekunden-Zeitraster eine Phasenverschiebung von 4 Nanosekunden ergibt, (wie sie laut Darstellung in Fig. 2C auch erforderlich ist).

Die Wirkungsweise der Schaltung für den Weg II ist analog zu der für den Weg I. Dieses in der DE-A-3 023 699 beschriebene Zwei-Weg-Verfahren erfordert, dass der Beginn eines das Impulsintervall einleitenden Markierungsimpulses mit einem 10-Nanosekunden-Zeitraster übereinstimmt. Wartezeiten, wie sie bei Verwendung nur einer einzigen Verzögerungsleitung (nur eines einzigen Weges) in Kauf genommen werden müssten, werden beim Zwei-Weg-Verfahren vermieden. Diese Wartezeiten waren in der DE-A-

3 023 699 mit dem Auftreten sogenannter «Einschwingvorgänge» begründet worden. In diese Wartezeit geht die Zeit mit ein, die vergehen müsste, um bei Verwendung einer einzigen Verzögerungsleitung bei Umschalten ihrer Abgriffe immer einen 10-Nanosekunden-Zeitraster-Beginn zu erhalten.

Unter Berücksichtigung nur dieser Betrachtungsweise würde sich eine Wartezeit (Einschwingzeit) von nahezu einer Periode des 10-ns-Zeitrasters des Quarzoszillators ergeben.

Praktisch gesehen sind jedoch die Wartezeiten aus zwei Gründen ungleich länger:

Beim Umschalten eines Verzögerungsleitungsabgriffes auf einen anderen kann es vorkommen, dass z.B. eine gerade abfallende Spannung nicht weiter abfallen kann, weil sie durch Zuschaltung zunächst erst wieder einmal ansteigt. In einem solchen Fall muss eine zusätzliche Zeit abgewartet werden, bis an dem neuen Verzögerungsleitungsabgriff eine neue für einen Zählvorgang geeignete Flanke auftritt.

Bei Verwendung bereits bekannter Feinverzögerungsleitungen mit um 100 Picosekunden gestaffelten Abgriffen (geeignet für die Verzögerung einmaliger Vorgänge, nicht geeignet für periodische Vorgänge im 100-MHz-Bereich) anstelle der Verzögerungsleitungen 302 bzw. 307 in Fig. 3 würde sich für die Umschaltung der 10-ns-Basis-Frequenz eine zusätzliche Wartezeit ergeben. Da diese Feinverzögerungsleitungen aus LC-Gliedern aufgebaut sind, die in ihrer Hintereinanderschaltung nicht den Frequenzgang und die Wellenwiderstandes-Konstanz eines Koaxkabels im LC-Ersatzschaltbild erreichen, treten zusätzliche Einschwingprobleme auf.

Das zuvor beschriebene Verfahren gemäss DE-A-3 023 699 hat zwei wesentliche Nachteile:

1. Der durch das Zwei-Weg-Verfahren bedingte schaltungstechnische Aufwand ist erheblich.

2. Die Justage-Toleranzen für die Verzögerungsleitungsabgriffe der Verzögerungsleitungen 302 und 307 (Fig. 3) pflanzen sich durch das gesamte System zur Erzeugung der gewünschten Impulsfolgen fort und verursachen entsprechende Ungenauigkeiten (Schwankungen des den Beginn der Impulsintervalle kennzeichnenden Referenzpunkte). Um die Justage-Toleranzen gering zu halten, wurde bisher mit hohem Aufwand die Verzögerungsleitung aus einer Vielzahl von Koax-Kabeln entsprechender Laufzeit gebildet.

3. Es ist nicht möglich Impulse zu erzeugen, deren Dauer grösser ist als die von zwei unmittelbar aufeinanderfolgender Impulsintervall – Wartezeit.

Die Impulsintervalldauer hat aus Spezifikationsgründen für viele Anwendungen eine obere Grenze, die dann auch zwangsweise für die zu erzeugenden Impulse gilt.

Zusammenfassend kann gesagt werden, dass es nach dem bekannten Zwei-Weg-Verfahren nicht möglich war Impulsintervalle und Impulse mit einer höheren zeitlichen Auflösung als im 1-Nanosekunden-Bereich zu erzeugen. Selbst wenn es möglich wäre, anstelle der Verzögerungsleitungen (302, 307 in Fig. 3) solche mit einer Zeitstaffel von 100-Picosekunden zu verwenden. (Vorsicht, die Justage solcher um 100-Picosekunden-gestaffelten Verzögerungsleitungsabgriffe bedingte einen nicht mehr vertretbaren Aufwand; Ungenauigkeiten pflanzen sich durch das gesamte System fort und gefährdeten die geforderten Zeitvorgaben für die zu erzeugende Impulsfolge). Bei einer Erhöhung der Basisfrequenz wären die heute zur Verfügung stehenden elektronischen Schaltungen, insbesondere die Zähler, von der Schnelligkeitsanforderung her gesehen, überfordert.

Es ist deshalb Aufgabe der Erfindung, ein Verfahren und eine Anordnung anzugeben, das es ermöglicht, Impulsintervalle in einem noch kleineren Zeitraster, als es bisher möglich war, vorzugeben und innerhalb dieser Impulsfolgen Impulse mit einem ebenfalls sehr kleinen Zeitraster zu plazieren. Vorzugsweise ist dabei an ein 100-Picosekunden-Zeitraster gedacht, das das bisher mögliche 1-Nanosekunden-Zeitraster um den Faktor 10 unterbietet.

Des weiteren ist es Aufgabe der Erfindung, die Impulse nicht mehr von dem schaltungsmässig schwer zu handhabenden 1-Nanosekunden-Zeitraster (einer Verzögerungsleistung mit um 1 ns gestaffelten Abgriffen) abzuleiten sondern auf ein leichter zu handhabendes grösseres Zeitraster, vorzugsweise 10 Nanosekunden, zurückzuführen.

Dadurch soll es ermöglicht werden, «quarzgenau» zu bleiben; Zeitabweichungen als Grundlage weiterer Ungenauigkeiten pflanzen sich dann nicht mehr durch das System fort.

Diese Aufgabe wird erfindungsgemäss in vorteilhafter Weise durch die im kennzeichnenden Teil des Anspruches 1 bzw. 6 angegebenen Massnahmen gelöst.

Vorteilhafte Weiterbildungen sind den Unteransprüchen zu entnehmen.

Die Erfindung ist als Verfahren und als Schaltung zur Durchführung dieses Verfahrens in den Zeichnungen dargestellt und wird im folgenden näher beschrieben.

Es zeigen:

Fig. 1 eine zusammenfassende Schaltungsübersicht zur Erzeugung von Impulsen im 100-Picosekunden-Zeitraster

Fig. 2A–2D gemäss der bekannten DE-A-3 023 699 in zeitlicher Relation zueinander:

ein 10-Nanosekunden-Impulsraster,

Impulsintervalle mit einer zeitlichen Auflösung von einer Nanosekunde und innerhalb dieser Impulsintervalle auftretende Impulse ebenfalls im 1-Nanosekunden-Zeitraster,

Fig. 3 gemäss der bekannten DE-A-3 023 699 eine zusammenfassende Darstellung einer Schaltung für ein sogenanntes Zwei-Weg-Verfahren zur Erzeugung von Impulsen vorgegebe-

ner Zeitrelation innerhalb vorgegebener Impuls-intervalle mit einer zeitlichen Auflösung von 1 Nanosekunde,

Fig. 4 eine detailliertere Darstellung einer Schaltung zur Erzeugung von Impulsen im 100-Picosekunden-Zeitraster innerhalb virtueller Impulsintervalle im 10-Nanosekunden-Zeitraster gemäss Fig. 1.

Fig. 5 eine noch detailliertere Darstellung der Schaltung nach Fig. 4 unter Berücksichtigung eines Schaltungsteiles zur Erzeugung der Impulsanstiegsflanken und eines anderen identischen Schaltungsteiles zur Erzeugung der Impulsabfall-flanken,

Fig. 6A-I unter anderem den zeitlichen Verlauf von Impulsintervallen und Impulsen (die innerhalb dieser Impulsintervalle auftreten sollen): in einem Fein- und Grob-Zeitraster mit entsprechenden Korrekturwerten,

Fig. 7 gemäss der bekannten DE-A-2 829 709 eine Schaltung zur Erzeugung von virtuellen Impulsintervallen im 10-Nanosekunden-Grob-Zeitraster unter Berücksichtigung von Korrekturwerten im 100-Picosekundenzeitraster.

Fig. 8 eine vereinfachte Darstellung zur Wirkungsweise des Schieberegisters in Fig. 5,

Fig. 9 eine vereinfachte Darstellung zur Auswahl eines Verzögerungsleitungsabgriffes durch Vorgabe eines Steuerwertes mit Hilfe einer Multiplex-Adressierschaltung,

Fig. 10 eine vereinfachte Darstellung einer steuerbaren Verzögerungsschaltung mit 10-Picosekunden-Zeitbereich.

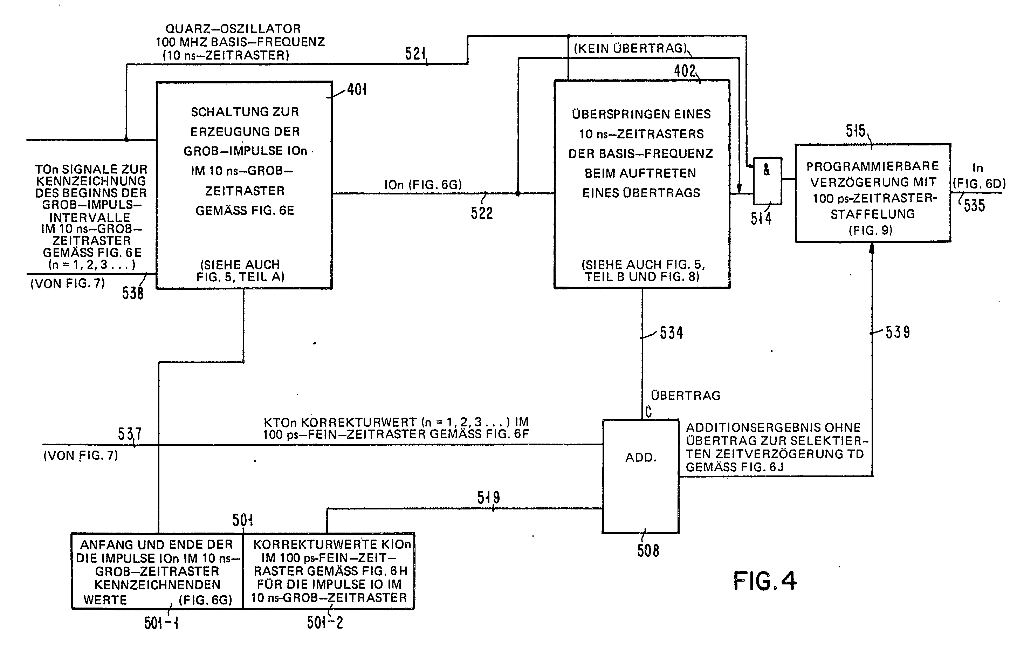

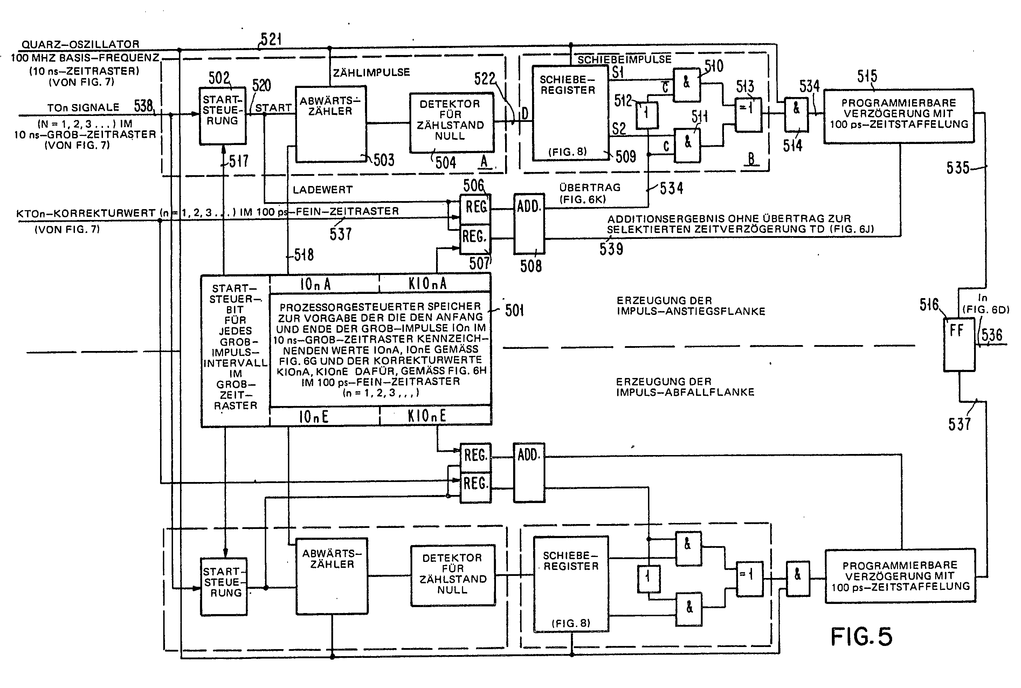

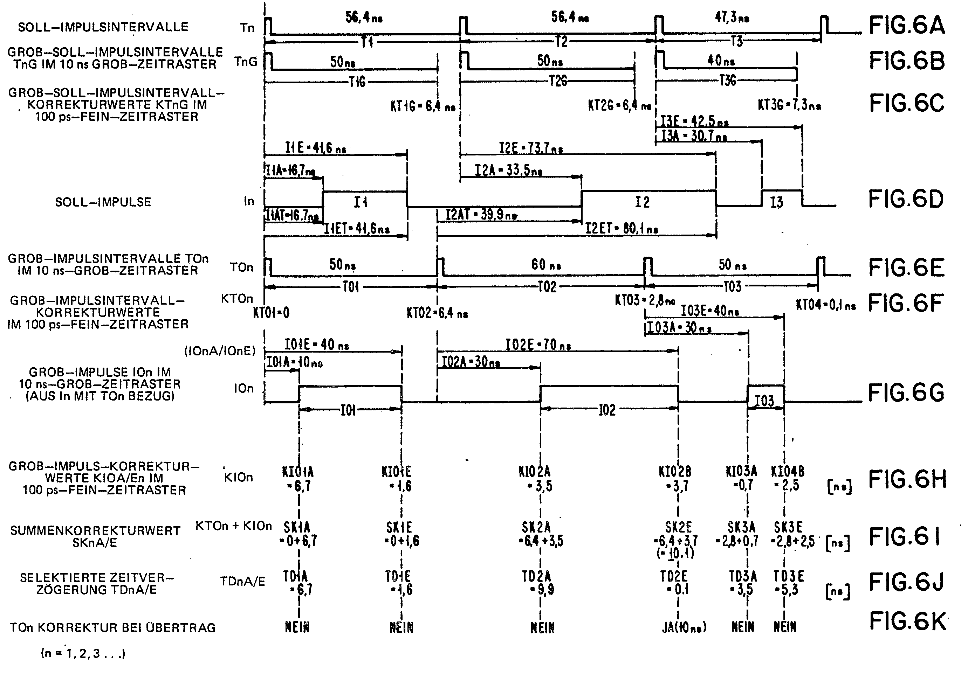

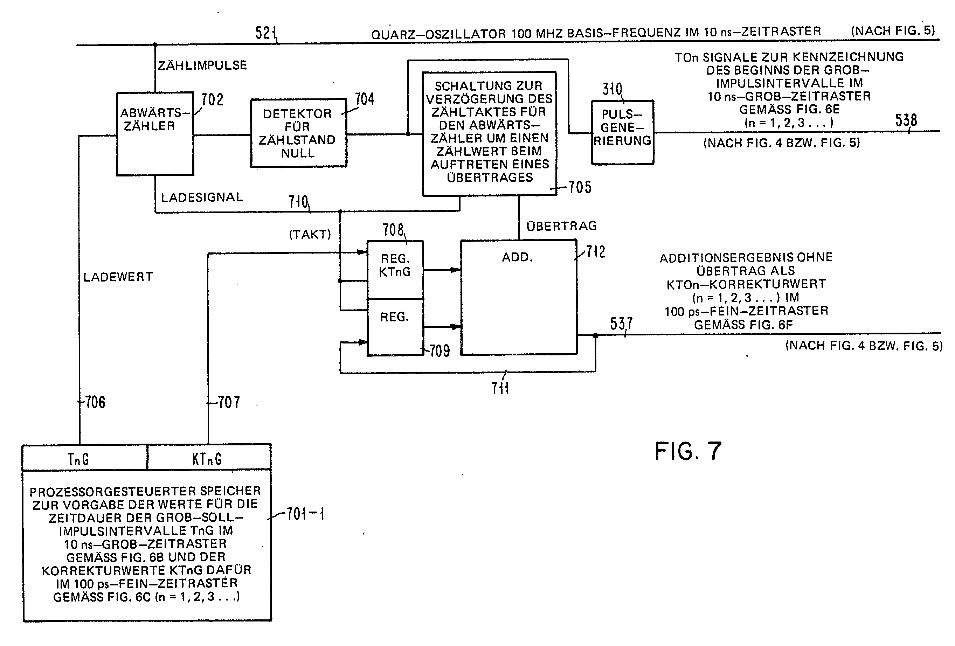

Das Verständnis der im folgenden beschriebenen Erfindung sei zunächst an den Darstellungen der Fig. 6A-6I geschult.

Erst nachfolgend wird dann auf Schaltungen zur Erzeugung der in den Fig. 6 dargestellten Impulsintervalle und Impulse eingegangen.

Die Fig. 6A-6I zeigen unter anderem den zeitlichen Verlauf von Impulsintervallen und Impulsen, die innerhalb dieser Impulsintervalle auftreten. Die Darstellungen haben den gleichen Zeitmassstab und sind aufeinander ausgerichtet. Dies macht es möglich, für bestimmte Zeitpunkte bei einer Grob-Zeitrasterdarstellung der Impulsintervalle und Impulse entsprechende Korrekturwerte anzugeben. Durch eine solche übersichtliche Darstellung ist es möglich, das Prinzip der Erfindung zu verstehen und darüber hinaus die Wirkungsweise der Schaltung zur Durchführung des erfindungsgemässen Verfahrens klarer verständlich zu machen.

Die quantitativen zeitlichen Angaben in den Darstellungen der Fig. 6 beziehen sich auf Werte, wie sie sich mit den zur Zeit verfügbaren Elektronik-Bauelementen gut realisieren lassen. Für schnellere Bauelemente soweit zur Zeit überhaupt verfügbar, wären die Zeitangaben entsprechend zu modifizieren. Mit anderen Worten, wenn sich das in dieser Anmeldung beschriebene Ausführungsbeispiel auf ein 100-Picosekunden-Zeitraster bezieht, so soll dies nicht ausschliessen, dass bei Verfügbarkeit entsprechend schnellere Elektronik-Bauelemente auch kleinere Zeitraster entsprechend der Lehre der Erfindung möglich sind.

In Fig. 6A sind drei unmittelbar aufeinanderfolgende soll-Impulsintervalle Tn gezeigt. Die Soll-Impulsintervalle sollen jeweils zwischen den Anstiegsflanken zweier aufeinanderfolgender Markierungspulse liegen. Allen Soll-Impulsintervallen liegt ein 100-Picosekundenzeitraster zugrunde, d.h. die Dauer eines jeden Soll-Impulsintervalles kann ganzzahlige Vielfache von 100 Picosekunden betragen. Das erste Soll-Impulsintervall hat eine Dauer von $T1 = 56,4$ Nanosekunden, das zweite ebenfalls eine Dauer von $T2 = 56,4$ Nanosekunden, während das dritte eine Zeitdauer von $T3 = 47,3$ Nanosekunden hat. Die Vorgabe der Zeitdauer der einzelnen Soll-Impulsintervalle erfolgt willkürlich. Ausserdem sei bemerkt, dass die Darstellung dieser Soll-Impulsintervalle zunächst nur einer fiktiven Vorstellung dient; diese Soll-Impulsintervalle müssen praktisch nicht durch eine Schaltung erzeugt werden; es genügt lediglich die Vorgabe der Zeitdauer für die einzelnen Soll-Impulsintervalle als digitale Werte.

Die Soll-Impulsintervalle nach Fig. 6A werden in Fig. 6B in Grob-Soll-Impulsintervalle TnG mit einem 10-Nanosekunden-Grob-Zeitraster mit einem jeweils zugeordneten Grob-Soll-Impulsintervall-Korrekturwert KTnG (Fig. 6C) aufgeteilt.

So stellt sich das Soll-Impulsintervall $T1 = 56,4$ ns (Fig. 6A) dar als Grob-Soll-Impulsintervall $T1G = 50$ ns (Fig. 6B) mit dem zugehörigen Grob-Soll-Impulsintervall-Korrekturwert $KT1G = 6,4$ ns. Aus der Summe von $T1G + KT1G = 50 + 6,4 = 56,4$ ns würde sich also wieder das Soll-Impulsintervall T1 ergeben).

Da die Grob-Soll-Impulsintervalle (Fig. 6B) jedoch zeitlich nicht unmittelbar einander anschliessen, werden an späterer Stelle aus den Angaben von Fig. 6B und Fig. 6C einander anschliessende Grob-Impulsintervalle T0n im 10-ns-Grob-Zeitraster (Fig. 6E) mit jeweils zugehörigen Grob-Impulsintervall-Korrekturwerten KT0n im 100-ps-Fein-Zeitraster (Fig. 6F) gebildet.

In Fig. 6D sind Soll-Impulse I gezeigt, deren Auftreten sich auf die einzelnen Soll-Impulsintervalle bezieht. So soll in fiktiver Vorstellung der Soll-Impuls I1 nach $I1A = 16,7$ Nanosekunden nach Beginn des Soll-Impulsintervalles T1 beginnen und nach $I1E = 41,6$ Nanosekunden nach Beginn des Soll-Impulsintervalles T1 enden.

Der zeitliche Bezug für Anfang und Ende des Impulses I2 ist der Beginn des Soll-Impulsintervalles T2. Der Soll-Impuls I2 soll nach $I2A = 33,5$ Nanosekunden nach Beginn von T2 beginnen und nach $I2E = 73,7$ Nanosekunden nach Beginn von T2 enden. Analoges gilt für den Soll-Impuls I3, der nach $I3A = 30,7$ Nanosekunden nach Beginn des von T3 beginnt und nach $I3E = 42,5$ Nanosekunden nach Beginn von T3 endet. Es sei ausdrücklich bemerkt, dass diese Zeitangaben willkürlich sind und wiederum einem 100-Picosekunden-Zeitraster unterliegen.

Ausserdem sei betont, dass die Impulsdauer eines Soll-Impulses so gross gewählt werden kann, dass sich dieser Soll-Impuls bis in eines der nachfolgenden Soll-Impulsintervalle hinein erstreckt. Als Beispiel sei auf den Soll-Impuls I2 verwiesen, der im Soll-Impulsintervall T2 beginnt und im Soll-Impulsintervall T3 endet.

Die in Fig. 6D gezeigte Soll-Impulsfolge soll erfindungsgemäss erzeugt werden. Die gezeigte Darstellung versteht sich nur als ein Beispiel für entsprechend vorzugebende Zeitrelationen.

Im vorgegebenen Beispiel (Fig. 6A und 6D) sind zur Kennzeichnung der Soll-Impulsfolge gemäss Fig. 6D lediglich die Werte für die Zeitdauer der einzelnen Soll-Impulsintervalle (Fig. 6A) und zum anderen (Fig. 6D) die auf den Beginn der einzelnen Soll-Impulsintervalle bezogenen Soll-Impulsbeginn- und Soll-Impulsendezeiten angegeben.

Ausgehend von diese Soll-Vorgaben bzw. den Angaben in den Fig. 6B und 6C werden nun (Fig. 6E) einander anschliessende Grob-Soll-Impulsintervalle T0n im 10-ns-Grob-Zeitraster gebildet (Fig. 6E).

Grob-Zeitraster bedeutet in diesem Zusammenhang beispielsweise, dass Grob-Impulsintervalle einem Zeitraster von 10 Nanosekunden unterliegen im Gegensatz zu dem 100-Picosekunden-Zeitraster gemäss Fig. 6A.

Auf diese Weise wird aus dem 56,4 Nanosekunden umfassenden Soll-Impulsintervall T1 (Fig. 6A) das nur 50 Nanosekunden umfassende Grob-Impulsintervall T01 (Fig. 6E). Da in Wirklichkeit jedoch das Soll-Impulsintervall T1 nach 50 Nanosekunden (01) nicht beendet ist, muss wie in Fig. 6F angegeben, zum Ende des T01 Grob-Impulsintervalles ein Korrekturwert $KT02 = 56,4-50 = 6,4$ Nanosekunden hinzugefügt werden, um nach gedachter Addition des Zeitwertes für T01 ($= 50$ Nanosekunden) zu diesem Korrekturwert $KT02 = 6,4$ Nanosekunden die Dauer des Soll-Impulsintervalles T1 56,4 Nanosekunden zu erhalten.

Die Dauer von 60 Nanosekunden für das Grob-Impulsintervall T02 ergibt sich wie folgt: Zur Dauer des Soll-Impulsintervalles T2 56,4 Nanosekunden ist der Korrekturwert $KT02 = 6,4$ Nanosekunden (am Ende von T01) hinzuzuzählen. Die sich ergebende Summe $56,4+6,4 = 62,8$ Nanosekunden wird im 10-Nanosekunden-Zeitraster (Fig. 3E) zu einer Zeitdauer von 60 Nanosekunden für T02 reduziert. Der verbleibende Korrekturwert KT03, der am Ende von T02 zu berücksichtigen ist, beträgt $62,8-60 = 2,8$ Nanosekunden.

Analoges gilt für T03. Zu der Zeitdauer des Soll-Impulsintervalles T3 47,3 Nanosekunden wird der Korrekturwert $KT03 = 2,8$ Nanosekunden (am Ende von T02) hinzugezählt. Von den sich ergebenden $47,3+2,8 = 50,1$ Nanosekunden entfallen auf das Grob-Zeitraster von T03 50 Nanosekunden und $50,1-50 = 0,1$ Nanosekunden auf den Korrekturwert KT04.

Ebensogut lassen sich die Angaben für Fig. 6E und Fig. 6F auch aus den Angaben von Fig. 6B und Fig. 6C ableiten.

Auf diese Grob-Impulsintervalle T0n (Fig. 6E) werden nun die von den gewünschten Soll-Impulsen I (Fig. 6D) abzuleitenden Grob-Impulse I0n

(Fig. 6G) im Grob-Zeitraster bezogen. Grob-Zeitraster bedeutet, dass die Grob-Impulse einem 10-Nanosekunden-Grob-Zeitraster unterliegen und keinem 100-Picosekunden-Grob-Zeitraster wie in Fig. 6D. Grob-Impulsbeginn und Grob-Impulsende werden jeweils auf den Beginn des zugehörigen Grob-Impulsintervalles im Grob-Zeitraster bezogen. Wenn gemäss Fig. 6D der Soll-Impulsbeginn von I1 bei $I1A = 16,7$ Nanosekunden nach dem Beginn des Soll-Impulsintervalles T01 (Fig. 6E) liegt, so muss für das 10-Nanosekunden-Grob-Zeitraster (Fig. 6G) der Beginn des Grob-Impulses I01 bei $I01A = 10$ Nanosekunden liegen. Die Differenz $16,7-10 = 6,7$ Nanosekunden wird durch einen für den Grob-Impulsbeginn von I01 (Fig. 6G) zu vermerkenden Korrekturwert $KT01A = 6,7$ Nanosekunden berücksichtigt. Da das Ende von I1 bei $I1E = 41,6$ Nanosekunden (Fig. 6D) nach Beginn von T01 (Fig. 6E) liegt, muss das Grob-Impulsende von I01 im 10-Nanosekunden-Zeitraster (Fig. 6G) bei 40 Nanosekunden (I01E) liegen. Der Korrekturwert KI01E für das Grob-Impulsende von I01 beträgt somit $41,6-40 = 1,6$ Nanosekunden. Die Festlegung des Impulses I02 in Fig. 6G geschieht wie folgt: Der Soll-Impulsbeginn von I2 (Fig. 6D) liegt bei $I2A = 33,5$ Nanosekunden nach dem Beginn des Soll-Impulsintervalles T2. Von diesem Wert entfallen 30 Nanosekunden auf das Grob-Zeitraster und es verbleiben 3,5 Nanosekunden als Korrekturwert KI02A für den Beginn des Impulses I02 (Fig. 6G). Der Beginn des Impulses I02 wird auf den Beginn des T02 Grob-Impulsintervalles bezogen, auch wenn der Beginn dieses T02 Grob-Impulsintervalles nicht mit dem Beginn des T2 Soll-Impulsintervalles übereinstimmt. Der Korrekturwert $KT02 = 6,4$ Nanosekunden, der die zeitliche Differenz des Beginns beider Soll-Soll-Impulsintervalle T2 und T02 ausmacht, wurde bereits in Fig. 6D am Ende von T01 berücksichtigt. Zur Festlegung des Endes des Grob-Impulses I02 gelten analoge Überlegungen. Wie aus Fig. 6D zu ersehen ist, liegt das Ende des Impulses I2 bei $I2E = 73,7$ Nanosekunden nach dem Beginn des Soll-Impulsintervalles T2. Dieser Wert 73,7 Nanosekunden wird aufgeteilt in $I02E = 70$ Nanosekunden für die Grob-Zeitrasterdarstellung in Fig. 6G und in einen Korrekturwert KI02B von $73,7-70 = 3,7$ Nanosekunden (Fig. 6H) für das Impulsende von I02. Auf diese Weise ist der Impulsbeginn von I02 auf 30 Nanosekunden nach Beginn des T02 Grob-Impulsintervalles (Fig. 6E) und das Ende des Impulses I02 auf 70 Nanosekunden nach Beginn des T02 (Fig. 6E) Grob-Impulsintervalles festgelegt.

Für die Festlegung des Grob-Impulses I03 (Fig. 6G) gelten wiederum analoge Betrachtungen: Da der Impuls I3 (Fig. 6D) $I3A = 30,7$ Nanosekunden nach Beginn des T3 Soll-Impulsintervalles beginnt, wird dieser Wert in $I03A = 30$ Nanosekunden (Fig. 6G) und in einen Korrekturwert KI03A von $30,7-30 = 0,7$ Nanosekunden (Fig. 6H) für den Impulsbeginn aufgeteilt. Das Impulsende von I03 liegt entsprechend bei $I03E = 40$ Nanosekunden und ist mit einem Korrekturwert KI04B von 2,5 Nanosekunden (Fig. 6H) versehen.

Auf diese Weise werden aus den Soll-Impulsintervallen Tn in Fig. 6A Grob-Impulsintervalle T0n im Grob-Zeitraster (Fig. 6E) mit entsprechenden Korrekturwerten KT0n (Fig. 6F) geschaffen. Aus den Angaben für die Grob-Impulsintervalle und den dazugehörigen Korrekturwerten können die ursprünglichen Soll-Impulsintervalle (Fig. 6A) generiert werden.

Andererseits werden die gewünschten Soll-Impulse I (Fig. 6D) ebenfalls in Grob-Impulse I0n (Fig. 6G) mit entsprechenden Korrekturwerten KI0n (Fig. 6H) überführt. Aus den Angaben für I0n und KI0n ist es möglich, die ursprünglich gewünschten Soll-Impulse I (Fig. 6D), – bezogen auf den Beginn der diesen Impulsen zugeordneten Soll-Impulsintervalle Tn – zu rekonstruieren.

Darüberhinaus ist es möglich, aus den Angaben von T0n, KT0n, I0n und KI0n die ursprünglich gewünschten Soll-Impulse In (Fig. 6D) vollends zu rekonstruieren. Dafür geht man von den Grob-Impulsen I0n (Fig. 6G) unter Berücksichtigung folgender bekannter Werte aus:

zeitliche Länge der einzelnen Grob-Impulsintervalle T0n (Fig. 6E)

Korrekturwerte KT0n für T0n (Fig. 6F),

die Impulsbeginn und Impulsende der Grob-Impulse definierenden Zeitwerte – bezogen auf den Beginn der Grob-Impulsintervalle T0n

Korrekturwerte KI0n (Fig. 6H) für den Beginn und das Ende der Grob-Impulse I0n (Fig. 6G).

Aus diesen bekannten Werten können die ursprünglich gewünschten Soll-Impulse In (Fig. 6D) generiert werden. Dazu sind lediglich die entsprechenden Korrekturwerte KT0n (Fig. 6F) für T0n und die entsprechenden Korrekturwerte KI0n (Fig. 6H) für I0n zu summieren. Dadurch ergeben sich die in Fig. 6I gezeigten Summenkorrekturwerte SKnA/E = KT0n+KI0n. Der Summenkorrekturwert SKA1 für den Beginn des Grob-Impulses I01 ergibt sich durch Addition von KT01 und KI01A zu 0+6,7 = 6,7 Nanosekunden.

Der Korrekturwert SKA1E für das Ende des Grob-Impulses I0n ergibt sich durch Summation des Korrekturwertes KI01E [= 1,6 Nanosekunden (Fig. 6H)] zu dem Korrekturwert KT01 (= 0 Nanosekunden) für den Beginn des Grob-Impulsintervalles T01. In Analogie dazu ergibt sich der Summenkorrekturwert SK2A für den Beginn des Grob-Impulses I02 durch Summierung des Korrekturwertes KI02A (= 3,5 Nanosekunden) zu dem Korrekturwert KT02 (= 6,4 Nanosekunden) für den Beginn des Grob-Impulsintervalles T02.

Der Summenkorrekturwert SK2E für das Ende des Grob-Impulses I02 ergibt sich aus der Summierung des Korrekturwertes KI02B (= 3,7 Nanosekunden) für das Ende von I02 zu dem Korrekturwert KT02 (= 6,4 Nanosekunden) für den Beginn des Grob-Impulsintervalles T02. Die Korrekturwerte SK3A und SK3E für den Grob-Impuls I03 werden entsprechend gebildet.

Bei der Bildung der Summenkorrekturwerte SKnA/E werden also die Korrekturwerte KI0n für die Grob-Impulse I0n jeweils zu den Korrekturwerten der diesen Impulsen (I01, I02, I03 ...) jeweils zugeordneten Grob-Impulsintervalle T0n (T01, T02, T03 ...) addiert (n = 1, 2, 3, ...).

Bei dieser Addition kann das Additionsergebnis einen Zehnerübertrag bedingen, wie es z.B. bei der Bildung des Summenkorrekturwertes SK2E = 6,4+3,7 = 10,1 Nanosekunden der Fall ist. In einem solchen Fall wird der auftretende Zehnerübertrag (1) später in besonderer Weise berücksichtigt.

Sämtliche Summenkorrekturwerte SKnA/E (Fig. 6I) werden ohne Berücksichtigung eines eventuell auftretenden Zehnerübertrages in Fig. 6J als selektierte Zeitverzögerungswerte TDnA/E (TD1A = 6,7 Nanosekunden; TD1E = 1,6 Nanosekunden, TD2A = 9,9 Nanosekunden TD2E = 0,1 Nanosekunden usw.) mit Bezug auf Impulsbeginn und Impulsende der Grob-Impulse I0n angegeben. Ein bei der Bildung des Summenkorrekturwertes auftretender Zehnerübertrag (z.B. bei Bildung des Wertes SK2E) wird in Fig. 6K berücksichtigt. In dieser Darstellung wird die für einen Zehnerübertrag erforderliche T0n-Korrektur zum Zeitpunkt des Auftretens des Übertrages vermerkt. Dadurch ist ein Hinweis gegeben, dass zu diesem Zeitpunkt neben TDnA/E auch dieser Übertrag zu berücksichtigen ist. Der Zehnerübertrag entspricht in dem angegebenen Ausführungsbeispiel einem Wert von 10 Nanosekunden.

Es versteht sich, dass aus den Werten der selektierten Zeitverzögerung TDnA/E (Fig. 6J) und der T0n-Korrektur bei einem Zehnerübertrag (Fig. 6K) – ausgehend von den Grob-Impulsen I0n (Fig. 6G) – die gewünschten Impulse In (Fig. 6D) generiert werden können.

Als Beispiel sei angegeben, dass sich I1A = 16,7 Nanosekunden (Fig. 6D) aus der Summe von I01A = 10 Nanosekunden und von TD1A = 6,7 Nanosekunden bilden lässt.

Die anderen Werte werden wie folgt gebildet: I1E = I01E (= 40 ns) + TD1E (= 1,6 ns) = 41,6 ns. Zur Ermittlung der Anfangs- und Endwerte für I2 (Fig. 6D) bezieht man sich auf den bekannten Zeitpunkt, an dem T02 beginnt. Von diesem Zeitpunkt an gerechnet, wird zu I02A (= 30 ns) der Wert TD2A (= 9,9 ns) addiert und es ergeben sich I2AT = 39,9 Nanosekunden. Dieser Wert I2AT kennzeichnet den Beginn des Impulses I2 (Fig. 6D), jedoch auf den Beginn des T02-Grob-Impulsintervalles bezogen.

Eine Probe ergibt, dass diese Vorgehensweise zum richtigen Ergebnis führt: Der Impulsbeginn von I2 liegt, bezogen auf den Beginn des Impulsintervalles T01 (bzw. T1) bei 56,4 ns (Fig. 6A) +33,5 ns (= I2A, Fig. 6D) = 89,9 ns. Der zeitliche Beginn des T02-Grob-Impulsintervalles liegt bei 50 Nanosekunden. Wenn man den Impulsbeginn von I2 auf diese 50 Nanosekunden zurückbezieht, so liegt der Impulsbeginn von I2 bei 89,9–50 = 39,9 Nanosekunden bezogen auf den Anfang von T02.

Dieser Wert von 39,9 Nanosekunden ergibt sich jedoch wie bereits erwähnt aus der Addition

von 30 Nanosekunden (I02A) zu 9,9 Nanosekunden (TD2A) (30+9,9 = 39,9).

Für die Bestimmung des Zeitwertes für das Ende von I2, bezogen auf den Beginn des Soll-Impulsintervalles T02 ist folgende Rechnung auszuführen: 70 Nanosekunden (I02E) +0,1 Nanosekunden (TD2E) +10 Nanosekunden (welche sich aus dem Zehnerübertrag bei der Bildung des Summenkorrekturwertes SK2E ergaben), d.h. 70+0,1+10 =80,1 ns.

Es lässt sich zur Probe leicht nachweisen, dass auch diese Rechnung stimmt: Würde man das Ende von I2 auf den Beginn von T01 zurückbeziehen, so wäre zu der Zeitdauer von T01 = 50 Nanosekunden der Wert von 80,1 Nanosekunden zu addieren und es ergäben sich 130,1 Nanosekunden. Zu dem gleichen Ergebnis käme man, wenn man zu der Zeitdauer von T1 = 56,4 Nanosekunden den Wert I2E = 73,7 Nanosekunden hinzuaddiert. Es ergäben sich ebenfalls 130,1 Nanosekunden.

Entsprechende Rechnungen sind zur Generierung der Anfangs- und Endwerte für den Impuls I3 aus den Werten I03A und I03E in Verbindung mit den selektierten Zeitverzögerungswerten TD3A und TD3B anzustellen. Zehnerüberträge treten hierbei nicht auf und sind deshalb auch nicht zu berücksichtigen.

Zusammenfassend kann gesagt werden, dass die Zeitangaben für den Anfang und das Ende der Soll-Impulse I (Fig. 6D) bezogen auf den Anfang der ihnen zugeordneten Soll-Impulsintervalle im Grob-Zeitraster wie folgt generiert werden:

I1AT = I01A + TD1A + Zehnerübertrag*
I1ET = I01E + TD1E + Zehnerübertrag*
I2AT = I02A + TD2A + Zehnerübertrag*
I2AE = I02E + TD2E + Zehnerübertrag*
usw. (* falls ein solcher anfällt).

Es ist zu beachten, dass sich die errechneten Werte auf den Beginn der Grob-Impulsintervalle (Fig. 6E) und nicht auf den Beginn der Soll-Impulsintervalle T (Fig. 6A) beziehen.

Eine Übereinstimmung ergibt sich lediglich für die Werte I1A = I1AT und I1E = I1ET, weil der Beginn des Soll-Impulsintervalles T1 mit dem Beginn des Grob-Impulsintervalles T01 zusammenfällt.

Die Generierung der Angaben für die Soll-Impulse In aus den IOn-Werten (I01A, I01E, I02A, I02E etc.) in Fig. 6G, den selektierten Zeitverzögerungswerten TDnA/E (Fig. 6J) und den Zehnerüberträgen (Fig. 6K) ist unproblematisch, da die Zeitwerte für die Grob-Impulsintervalle T0n (Fig. 6E) bekannt sind. Dadurch ist es möglich, den Beginn der Soll-Impulse I (Fig. 6D) jeweils auf den Beginn der Grob-Impulsintervalle (Fig. 6E) zurückzubeziehen.

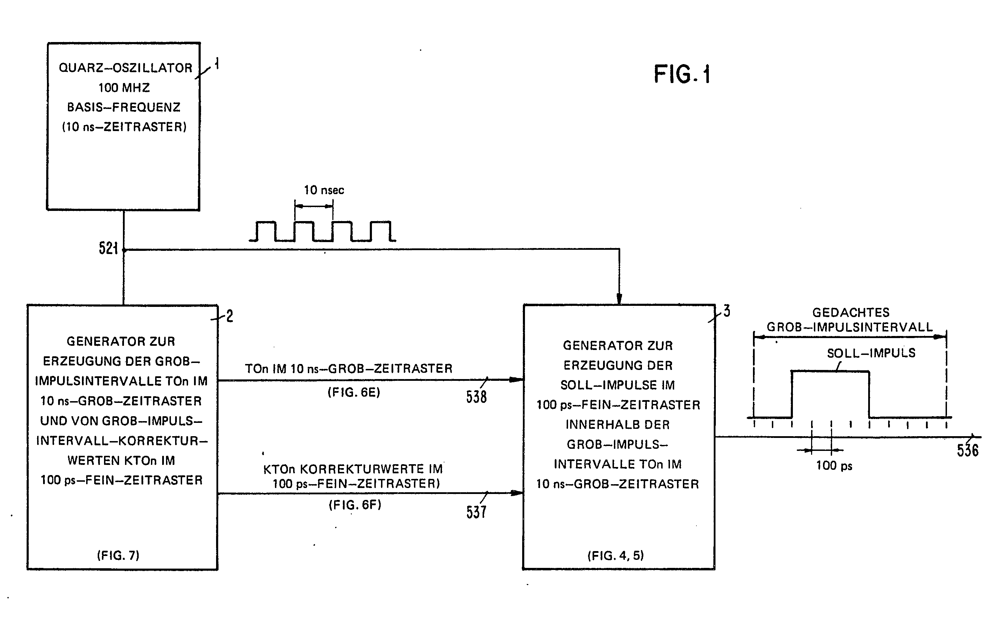

In Fig. 1 ist eine zusammenfassende Schaltungsübersicht zur Erzeugung von Soll-Impulsen In (gemäss Fig. 6D) auf Leitung 536 mit vorgegebenen Zeitrelationen im 100-Picosekunden-Zeitraster gezeigt.

Von einem Quarzoszillator 1 mit einer 100-MHz-Basisfrequenz wird ein 10-Nanosekunden-Zeitraster abgeleitet, das sowohl einem Generator 2 (zur Erzeugung von Grob-Impulsintervallen T0n im 10-Nanosekunden-Grob-Zeitraster gemäss Fig. 6E auf Leitung 538 und von Korrekturwerten KT0n im 100-Picosekunden-Fein-Zeitraster gemäss Fig. 6F auf Leitung 537) als auch einem Generator 3 (zur Erzeugung von Soll-Impulsen In gemäss Fig. 6D im 100-Picosekunden-Fein-Zeitraster innerhalb der Grob-Impulsintervalle T0n im 10-Nanosekunden-Grob-Zeitraster) auf Leitung 521 zugeführt wird.

Das Prinzip der Wirkungsweise des Generators 2 ist nicht neu, und bereits in der DE-A-2 829 709 beschrieben. Es wird nochmals in Zusammenhang mit der in Fig. 7 gezeigten Schaltung erklärt.

Der Generator 3 stellt das eigentliche Kernstück der Erfindung dar. Seine Wirkungsweise wird aus Gründen eines leichteren Verständnisses zunächst anhand von Fig. 4 erklärt, deren Schaltung später in Fig. 5 eine noch detailliertere Darstellung erfährt.

In Fig. 7 ist gemäss der bekannten DE-A-2 829 709 eine Schaltung zur Erzeugung von Grob-Impulsintervallen T0n (Fig. 6E) im 10-Nanosekunden-Grob-Zeitraster unter Berücksichtigung von Korrekturwerten KT0n (Fig. 6F) im 100-Picosekunden-Fein-Zeitraster gezeigt. Die Erzeugung der Korrekturwerte ist nicht Gegenstand der DE-A-2 829 709, jedoch hat dieses Merkmal nur einen leicht modifizierenden Einfluss auf die bekannte Schaltung. Im folgenden werden unter Verzicht auf in DE-A-2 829 709 beschriebene Einzelheiten nur die für das Verständnis wesentlichen Erläuterungen gegeben. Es sei betont, dass diese in Fig. 7 gezeigte Schaltung in Zusammenhang mit der vorliegenden Erfindung dazu dienen soll

a) aufgrund digitaler Zeitwerte, welche die Dauer der Grob-Impulsintervalle im 10-Nanokunden-Grob-Zeitraster gemäss Fig. 6C kennzeichnen sollen, T0n-Signale zur Kennzeichnung des Beginne dieser Grob-Impulsintervalle zu erzeugen (n = 1, 2, 3, ...)

b) lediglich die Korrekturwerte KT0n (Fig. 6F) für diese Grob-Zeitrasterwerte der Grob-Impulsintervalle (Fig. 6E) als Digitalwert im 100-Picosekunden-Fein-Zeitraster zur Verfügung zu stellen (n = 1, 2, 3, ...).

In einem Speicher 701-1 (Fig. 7) werden prozessgesteuert nacheinander für jedes Grob-Impulsintervall im Grob-Zeitraster der TnG-Wert (Fig. 6b) und der KTnG-Wert (Fig. 6C) zur Verfügung gestellt. Der TnG-Wert wird über Leitung 706 in einen Abwärtszähler 702 geladen, der von der Basisfrequenz (Leitung 521) abwärts gezählt wird. Bei Erreichen des Zählerstandes 0 wird durch einen Zählstand-Null-Detektor 704 ein Signal abgegeben, welches den Beginn bzw. das Ende eines Grob-Impulsintervalles im Grob-Zeitraster kennzeichnet. Dieses Signal wird in dem Schaltungsteil 310 einer Pulsgenerierung für das gewünschte T0n-Signal auf Leitung 538 unterzogen: Beim Autreten eines Übertrages bei einem an späterer Stelle beschriebenen Additionsvorganges wird durch die Schaltung 705 der Zähltakt für den Abwärtszähler um einen Zählwert verzögert. Mit dem Auftreten des TnG-Wertes auf Leitung 706 soll aber auch auf Leitung 707 der Korrekturwert KTnG für das entsprechende Grob-Impulsintervall zur Verfügung stehen. Dieser KTnG-Wert wird in das Register 708 geladen, von wo aus er einem Addierer 712 zugeführt wird. Der zweite Eingang dieses Addierers ist mit einem Register 709 verbunden, in dem zu diesem Zeitpunkt noch der Wert 0 gespeichert sein soll. Durch den Addierer 712 werden die Inhalte der Register 708 und 709 addiert und die Additionssumme (ohne Berücksichtigung eines möglicherweise anfallenden Zehnerübertrages) auf der Leitung 537 als FKTOn-Korrekturwert (n = 1, 2, 3,...) im 100-Picosekunden-Fein-Zeitraster gemäss Fig. 6F zur Verfügung gestellt. Mit dem Auftreten eines TOn-Signales auf Leitung 538 steht auf Leitung 537 auch der zugehörige KT0-Korrekturwert zur Verfügung.

Das Additionsergebnis wird über Leitung 711 dem Register 709 zugeführt, um später für das nachfolgende Grob-Impulsintervall Berücksichtigung zu finden. Ein sich möglicherweise am Addierer 712 ergebender Zehnerübertrag wird der Schaltung 705 zugeführt. Beim Auftreten eines Zehnerübertrages bewirkt diese einen Zähler enthaltende Schaltung 705 über Leitung 710 eine Verzögerung des Ladevorganges des Abwärtszählers 702 für das nachfolgende Grob-Impulsintervall um einen Zählwert (entspricht 10 Nanosekunden).

Von Leitung 710 werden die beiden Register 708 und 709 getaktet. Auf diese Weise dient die in Fig. 7 wiedergegebene Schaltung zur Vorgabe der Grob-Impulsintervalle gemäss Fig. 6E auf Leitung 538 und der entsprechenden Korrekturwerte gemäss Fig. 6F auf Leitung 537.

In Fig. 4 ist ein Schaltbild zur Erzeugung einer Impulsfolge In (gemäss Fig. 6D) gezeigt.

Diese Schaltung soll zunächst nur einem leichteren Verständnis der Erfindung dienen; spezielle Einzelheiten dieser Schaltung sind deshalb erst in Fig. 5 beschrieben. Aus Gründen der Übersicht wurde in Fig. 4 darauf verzichtet, separate Schaltungsteile für die Erzeugung der Impulsanstiegsflanken und der Impulsabfallflanken anzugeben. Diese Vereinfachung gilt jedoch nicht mehr in Fig. 5.

Auf Leitung 521 in Fig. 4 steht die 100-MHz-Basisfrequenz des Quarzoszillators (10-Nanosekunden-Zeitraster) zur Verfügung. Auf Leitung 538 erscheinen die von der Schaltung nach Fig.7 erzeugten TOn-Signale zur Kennzeichnung des Beginns der Grob-Impulsintervalle im 10-Nanosekunden-Grob-Zeitraster (gemäss Fig. 6E, n = 1, 2, 3,...). Auf Leitung 537 stehen die ebenfalls von der Schaltung in Fig. 7 erzeugten KTOn-Korrekturwerte (n = 1, 2, 3,...) im 100-Picosekunden-Fein-Zeitraster gemäss Fig. 6F zur Verfügung. Ausserdem wird vorausgesetzt, dass in einem Teil 501-1 eines prozessorgesteuerten Speichers 501 Werte zur Verfügung stehen, die Anfang und Ende der die Grob-Impulse I0n im 10-Nanosekunden-Grob-Zeitraster, und in einem anderen Teil

501-2 Korrekturwerte KI0n im 100-Picosekunden-Zeitraster kennzeichnen (gemäss Fig. 6G und Fig. 6H). Aus der auf Leitung 538 und der aus dem Speicherteil 501-1 Information werden unter Bezug auf die Basisfrequenz von einer Schaltung 401 die Impulse I0n im 10-Nanosekunden-Grob-Zeitraster gemäss Fig. 6G auf Leitung 522 erzeugt. Diese Impulse werden, sofern bei einem noch näher zu erläuternden Additionsvorgang kein Zehnerübertrag auftritt, einem UND-Glied 514 zugeführt, auf dessen zweiten Eingang die Basisfrequenz auf Leitung 521 geführt ist (die Funktion dieses UND-Gliedes ist im Zusammenhang mit Fig. 5 näher beschrieben). Der Ausgang dieses UND-Gliedes 514 führt auf eine Schaltung 515, welche eine programmierbare Verzögerung mit 100-Picosekunden-Zeitrasterstaffelung ermöglicht.

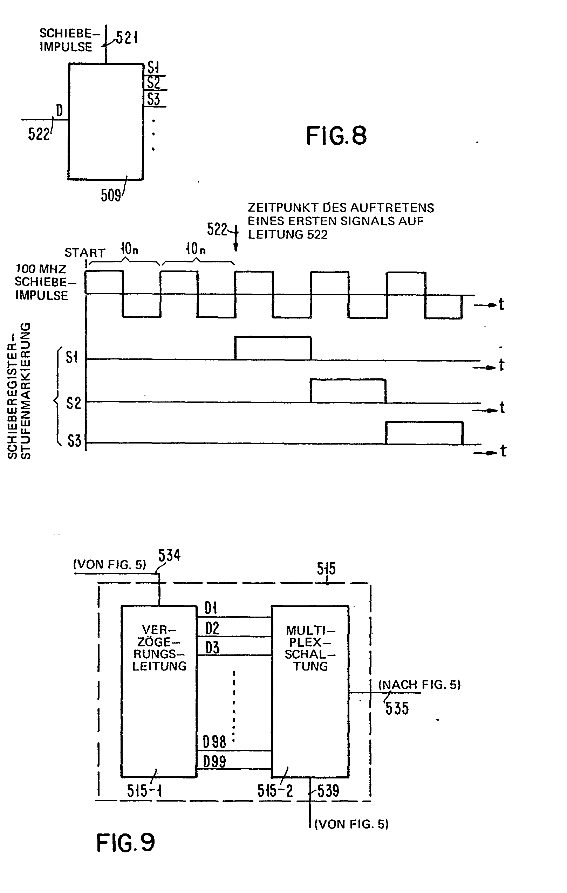

In Fig. 9 ist gezeigt, wie sich die Schaltung 515 beispielsweise realisieren lässt. Hier an dieser Stelle mag der Hinweis genügen, dass man sich die Schaltung 515 als eine Verzögerungsleitung mit um jeweils 100 Picosekunden gestaffelten Abgriffen vorstellen kann. Welcher Abgriff angesteuert wird, wird durch einen Steuerwert auf Leitung 539 vorgegeben. Am Ausgang der Schaltung 515 steht auf Leitung 535 die gewünschte Impulsfolge In (gemäss Fig. 6D) im 100-Picosekunden-Zeitraster zur Verfügung.

Im folgenden wird beschrieben, durch welche schaltungstechnischen Massnahmen es möglich ist, die Grob-Impulsfolge I0 im 10-Nanosekunden-Grob-Zeitraster unter Berücksichtigung der Korrekturwerte KI0n im Speicherteil 501-2 in eine Soll-Impulsfolge In (gemäss Fig. 6D) im 100-Picosekunden-Zeitraster zu überführen. Für diesen Zweck ist ein Addierer 508 mit zwei Eingängen 537 und 519 vorgesehen. Der Eingang 537 führt wie bereits erwähnt die KTOn-Korrekturwerte im 100-Picosekunden-Fein-Zeitraster gemäss Fig. 6F; über die Leitung 519 werden die Korrekturwerte KI0n im 100-Picosekunden-Fein-Zeitraster (gemäss Fig. 6H) für die Grob-Impulse I0n im 10-Nanosekunden-Grob-Zeitraster geliefert. Der Addierer 508 stellt das Additionsergebnis ohne Berücksichtigung eines möglicherweise auftretenden Übertrages zur selektierten Zeitverzögerung gemäss Fig. 6J auf Leitung 533 zur Verfügung. Ein sich möglicherweise bei der Addition ergebender Übertrag C wird auf Leitung 534 an eine Schaltung 402 weitergegeben. Diese Schaltung 402 dient dazu, dass beim Auftreten eines Übertrages ein 10-Nanosekunden-Zeitraster der Basisfrequenz übersprungen wird. Diese Funktion entspricht der in Fig. 6K angegebenen TOn-Korrektur bei Übertrag. Wenn sich also bei der Addition der Korrekturwerte auf den Leitungen 537 und 519 ein Zehnerübertrag auf Leitung 534 ergeben sollte, so braucht dieser lediglich durch Überspringen eines 10-Nanosekunden-Zeitrasters berücksichtigt zu werden. Einzelheiten der Schaltung 401 sind dem Teil A in Fig. 5 und Einzelheiten der Schaltung 402 sind dem Teil B von Fig. 5 bzw. der Fig. 8 zu entnehmen. Die Funktion der Schaltung 515 ist wie folgt zu verstehen: Verzögert wird lediglich ein einmaliger Vorgang, d.h. das Auftreten einer Impulsanstiegsflanke bzw. einer Impulsabfallflanke (einmaliger Vorgang im Gegensatz zu periodischen Vorgängen, wie z.B. das 10-ns-Basisfrequenz-Zeitraster). Der Verzögerungswert wird auf Leitung 533 vorgegeben. Beispiel: Beträgt der Verzögerungswert 400 Picosekunden = 0,4 Nanosekunden, so wird die Impulsflanke um diesen Wert verzögert. Wenn die Schaltung 515 durch eine steuerbare Verzögerungsleitung mit um jeweils um 100 Picosekunden gestaffelten Verzögerungsleitungsabgriffen gebildet wird, so würde der Verzögerungswert 0,4 Nanosekunden bewirken, dass jener Verzögerungsleitungsabgriff aktiviert wird, der diesem Wert entspricht. Die Schaltung in Fig. 4 soll zunächst lediglich in groben Zügen aufzeigen, wie aus der Vorgabe der Grob-Impulsintervalle im 10-Nanosekunden-Grob-Zeitraster und den dazugehörigen Korrekturwerten unter Berücksichtigung der Anfangs- und Endwerte der Grob-Impulse I0n im 10-Nanosekunden-Grob-Zeitraster und der dazugehörigen Korrekturwerte die gewünschte Soll-Impulsfolge In (Fig. 6D) erzeugt wird. Dabei sind die Grob-Impulse im 10-Nanosekunden-Grob-Zeitraster auf die Grob-Impulsintervalle ebenfalls im 10-Nanosekunden-Grob-Zeitraster bezogen. Nach ihrer Erzeugung müssen sie lediglich entsprechend dem Additionswert der Korrekturwerte für die Grob-Impulsintervalle und der Grob-Impulse zeitverschoben werden. Diese Zeitverschiebung erfolgt durch eine entsprechende Schaltung, die beim Auftreten eines Übertrages bei der Addition ein 10-Nanosekunden-Zeitraster der Basisfrequenz überspringt.

Fig. 5 zeigt nun eine detailliertere Schaltung für die Impulserzeugung innerhalb der durch die T0n-Signale (Fig. 6E) auf Leitung 538 definierten Grob-Impulsintervalle im 10-Nanosekunden-Grob-Zeitraster unter Berücksichtigung der Korrekturwerte KT0n (Fig. 6F) dafür auf Leitung 537. Diese Schaltung besteht aus einem oberen Teil zur Erzeugung der Impulsanstiegsflanke und einem unteren Teil zur Erzeugung der Impulsabfallflanke. In einem prozessorgesteuerten Speicher 501 wird nacheinander für jeden Impuls der I0nA-Wert (Fig. 6G) und der dazugehörige Korrekturwert KI0nA (Fig. 6H) für die Impulsanstiegsflanke bzw. der I0nE-Wert (Fig. 6G) und der KI0nE-Wert (Fig. 6H) für die Impulsabfallflanke zur Verfügung gestellt. Das «n» in den Ausdrücken I0nA, KI0nA, I0nE, KI0nE bedeutet, (n = 1, 2, 3, etc.), dass nacheinander für die Impulse I01, I02, I03 im Grob-Zeitraster (Fig. 6G) jeweils die den Impulsbeginn bzw. das Impulsende kennzeichnenden Werte I01A, I01E, I02A, I02E, I03A, I03E und die damit korrespondierenden Korrekturwerte KI01A, KI01E, KI02A, KI02E, KI03A, KI03E zur Verfügung gestellt werden. Des weiteren ist im Speicher 501 auch ein sogenanntes Start-Steuer-Bit vorgesehen (für jeden zu erzeugenden Impuls). Wenn im folgenden nur der obere Teil der Schaltung zur Erzeugung der Impulsanstiegsflanke erläutert wird, so gelten diese Erläuterungen analog auch für den unteren Teil der Schaltung zur Erzeugung der Impulsabfallflanke. Durch den auf Leitung 538 auftretenden Impuls zur Kennzeichnung des Beginns eines Grob-Impulsintervalles und durch das Start-Steuer-Bit aus dem Speicher 501 auf Leitung 517 wird eine Start-Steuerschaltung 502 zur Abgabe eines Startsignales auf Leitung 520 für einen nachgeschalteten Abwärtszähler 503 erzeugt. Der Zähler 503 wird mit dem auf die Weise erzeugten Signal über die Leitung 518 mit dem I0nA-Wert für den zu erzeugenden Impuls geladen. Dieser Zähler 503 wird durch die 100-MHz-Basisfrequenz (Leitung 521) abwärts gezählt. Beim Erreichen des Zählerstandes 0 liefert eine dem Zähler 503 nachgeschaltete Detektorschaltung 504 (für den Zählerstand 0) auf Leitung 522 ein Signal an ein Schieberegister 509, welches mit der 100-MHz-Basisfrequenz (Leitung 521) fortgeschaltet wird.

Einzelheiten zur Funktionsweise dieses Schieberegisters sind aus Fig. 8 zu ersehen.

Verschiebungsleitungen des in Fig. 8 dargestellten Typs sind käuflich (z.B. MC10141 der Firma Motorola).

Die einzelnen Ausgänge der Schieberegisterstufen sind mit S1, S2, S3, etc. gekennzeichnet. Tritt auf der Leitung 522, am sogenannten D-Eingang des Schieberegisters, ein Signal auf (bspw. wenn das dritte Zeitraster der Basisfrequenz beginnt), so bedingt das Auftreten dieses Impulses eine Markierung der mit S1 bezeichneten Schiebergisterstufe. Diese Markierung wird mit 100 MHz in Richtung der anderen auf S1 folgenden Schieberegisterstufen fortgeschaltet, wie es aus den zeitlichen Darstellungen in Fig. 7 hervorgeht. Von den Schieberegisterstufen werden in Schaltung (Fig. 5) lediglich die Anschlüsse S1 und S2 benutzt. Am S1-Ausgang tritt ein Signal nach Ablauf der Zeit auf, die zwischen dem Beginn des entsprechenden Grob-Impulsintervalles im 10-Nanosekunde-Grob-Zeitraster und der Impulsanstiegsflanke des Grob-Impulses im 10-Nanosekunden-Grob-Zeitraster liegt. Dieses Signal erscheint durch Fortschaltung mit der 100-MHz-Basisfrequenz 10 Nanosekunden später am S2-Ausgang des Schieberegisters. Hiervon wird Gebrauch gemacht, wenn es darum geht, eine 10-Nanosekunden-Verschiebung für den Grob-Impuls im 10-Nanosekunden-Grob-Zeitraster zu erreichen, sofern ein Zehnerübertrag (Fig. 6K) bei der Bildung des Summenkorrekturwertes SK auftritt.

Im folgenden wird beschrieben, wie es zur Bildung des Summenkorrekturwertes SK (Fig. 6I) kommt.

Auf Leitung 537 wird dem Register 506 der KT0n-Korrekturwert (Fig. 6F) für ein Grob-Impulsintervall mit 10-Nanosekunden-Grob-Zeitraster zugeführt. Gleichzeitig erhält ein Register 507 aus dem Speicher 501 den Korrekturwert KI0nA zugewiesen. Beide Register 506 und 507 werden von der Ausgangsleitung 520 der Startsteuerung 502 getaktet und geben ihren Inhalt an einen Addierer 508 weiter. Dieser Addierer verknüpft beide Werte zur Bildung des Summenkorrekturwertes

SKnA/E (Fig. 6I), wobei das Additionsergebnis (ohne Berücksichtigung eines Übertrages) auf der Leitung 539 zur Verfügung steht. Eventuell auftretende Zehnerüberträge C erscheinen auf der Leitung 534.

Im folgenden wird erklärt, wie die Schaltung (402 in Fig. 4, Teil B in Fig. 5) zum Überspringen eines 10-Nanosekunden-Zeitrasters beim Auftreten eines Zehnerübertrages arbeitet.

Der S1-Ausgang des Schieberegisters 509 ist mit einem UND-Glied 510 verbunden, der S2-Ausgang mit einem UND-Glied 511. Dem UND-Glied 510 wird ein durch das Negationsglied 512 negiertes Übertragssignal C zugeführt; dem UND-Glied 511 das nicht negierte Übertragssignal C. Die Ausgänge beider UND-Glieder 510 und 511 führen auf ein ODER-Glied 513, dessen Ausgang wiederum mit einem UND-Glied 514 verbunden ist. Auf den zweiten Eingang des UND-Gliedes 514 wird die 100-MHz-Basisfrequenz (auf Leitung 521) geführt. Wenn kein Übertrag auftritt, leitet das UND-Glied 510 den am S1-Ausgang des Schieberegisters 509 auftretende Signal weiter. Dieses Signal tritt zu einem Zeitpunkt auf, der der 10-Nanosekunden-Grob-Rasterzeit zwischen Grob-Impulsintervallbeginn und Grob-Impulsbeginn (siehe Fig. 6G) entspricht. Beim Auftreten eines Übertrages ist hingegen das UND-Glied 510 nicht mehr konditioniert und das UND-Glied 511 leitet das von S1 nach 10 ns auf S2 fortgeschaltete Signal weiter. Hierdurch ergibt sich aber gerade die gewünschte 10-Nanosekunden-T0n-Korrektur (Fig. 6K) der 100-MHz-Basisfrequenz mit dem Ergebnis, dass die Zeit zwischen Grob-Impulsintervallbeginn und Grob-Impulsbeginn um 10 Nanosekunden verlängert wird als der ursprüngliche I0nA-Zählwert vorgibt. Das UND-Glied 514 hat lediglich den Zweck, die Ausgangssignale der UND-Schaltungen 510 bzw. 511 mit den entsprechenden Zeitpunkten der 100-MHz-Basisfrequenz wieder zwangszusynchronisieren.

Das auf Leitung 539 gebildete Additionsergebnis ohne Übertrag dient der selektierten Zeitverzögerung (Fig. 6J) des den Impulsbeginn im 10-Nanosekunden-Grob-Zeitraster kennzeichnenden Signales auf Leitung 534. Wie bereits erwähnt, kann für die programmierbare Verzögerungsschaltung auch eine (in Fig. 9 dargestellte) Verzögerungsleitung mit um 100 Picosekunden gestaffelten Abgriffen verwendet werden.

In Fig. 9 ist die als käufliches Bauteil 515 verfügbare programmierbare Verzögerungsleitung 515-1 und die dazugehörige Multiplexschaltung 515-2 gezeigt. Der Eingang 534 zu dieser Verzögerungsleitung führt den für die Impulsanstiegsflanke massgebenden Spannungssprung. Die Verzögerungsleitung hat eine Reihe von Verzögerungsleitungsabgriffen D1 bis D99, die jeweils um 100 Picosekunden Zeitverzögerung gestaffelt sind.

Zur Durchschaltung eines bestimmten Verzögerungsleitungsabgriffes (entsprechend der selektierten Zeitverzögerung auf Leitung 539) dient die Multiplex-Schaltung 515-2. Sie schaltet entsprechend dem auf Leitung 539 gelieferten Digitalwert für die selektierte Zeitverzögerung den diesem Wert entsprechenden Verzögerungsleitungsabgriff auf den Ausgang 535 durch. Beträgt die selektierte Zeitverzögerung z.B. TD1A = 6,7 Nanosekunden = 670 Picosekunden = $67 \times 100$ Picosekunden, so wird der für diese Zeitverzögerung entsprechende Abgriff D67 auf Leitung 535 durchgeschaltet.

Die in Fig. 9 gezeigte Schaltungskombination (Verzögerungsleitung und Multiplexer) ist allgemein bekannt und z.B. als SPECLDL-121 von der Firma EC[2] (Engineered Components Company) California, USA zu beziehen. Sie wird deshalb auch nicht näher beschrieben.

Nach dieser sogenannten Feinverzögerung der Impulsanstiegsflanke durch die Verzögerungsschaltung 515 wird der verzögerte Impuls auf Leitung 535 einer Flipflop-Schaltung 516 zugeführt. Dadurch wird bewirkt, dass der Ausgang 536 des Flipflops auf «EIN» gesetzt wird. Dieses gleichbedeutend mit der Vorgabe der Anstiegsflanke für den gewünschten Soll-Impuls (z.B. I1 in Fig. 6D).

Es wurde bereits bemerkt, dass der untere Teil der Schaltung in Fig. 5 der Erzeugung der Impulsabfallflanke dient. Die Wirkungsweise dieses Teiles der Schaltung ist identisch mit dem oberen Teil der Schaltung zur Erzeugung der Impulsanstiegsflanke; sie wird deshalb nicht nochmals beschrieben. Es ist einleuchtend, dass der untere Teil dieser Schaltung für die ein Impulsende kennzeichnenden Werte I0nE, KI0nE wirksam ist, so dass letztlich ein das Impulsende kennzeichnendes Signal auf Leitung 537 ein Zurückschalten des Flipflop-516-Ausganges 536 bedingt und dadurch die Erzeugung des gewünschten Soll-Impulses (z.B. I1 in Fig. 6D) abgeschlossen ist.

Zusammenfassend kann gesagt werden, dass durch die erfindungsgemässe Schaltung die gewünschte Impulsfolge In (Fig. 6D) am Ausgang 536 des Flipflops 516 zur Verfügung steht. Bei ihrer Erzeugung geht man von der Vorstellung Soll-Impulsintervalle (Fig. 6A) aus, auf die die gewünschten Soll-Impulse In (Fig. 6D) bezogen werden. Unter Vorgabe eines Grobzeitrasters (z.B. 10 Nanosekunden) können gedanklich die Soll-Impulsintervalle Tn (Fig. 6A) in Grob-Impulsintervalle T0n (Fig. 6E) dieses Grobzeitrasters überführt werden in Verbindung mit entsprechenden Korrekturwerten KT0n (Fig. 6F).

Ebenso werden in gedanklicher Vorstellung die gewünschten Soll-Impulse In (Fig. 6D) in sogenannte Grob-Impulse I0n (Fig. 6G) in Verbindung mit entsprechenden Korrekturwerten KI0n (Fig. 6H) überführt.

Basierend auf diesen Werten T0n, KT0n, I0n und KI0n können die gewünschten Impulse In generiert werden. Die Zeitrelationen der gewünschten Impulse hängen vom Einzelfall der Anwendung ab.

Sollen beispielsweise schnelle Speicher oder Logik-Schaltkreise ausgetestet werden, so sind für den Test Soll-Impulse (bzw. Soll-Impulsintervalle) mit bestimmten Zeitrelationen, die vom Produkt her bestimmt werden, zu fordern.

Die zu erzeugende Soll-Impulsfolge In wird in Verbindung mit den Soll-Impulsintervallen durch entsprechende Zahlenwerte T1, T2, T3; I1A, I1E, I2A, I2E, I3A, I3E usw. umschrieben. Aufgrund dieser Werte werden nun unter Vorgabe eines Zeitrasters (z.B. des auf der 100-MHz-Quarzoszillator-Basisfrequenz basierenden 10-Nanosekunden-Zeitrasters) die TnG-, KTnG-, KT0n-, I0n- und KI0n-Werte berechnet (durch einen Computer). Sobald aber diese Werte in einem entsprechend prozessorgesteuerten Speicher verfügbar sind, geben zählergesteuerte Signale den Beginn der einzelnen Grob-Impulsintervalle T0n im Grob-Zeitraster (Fig. 6E) in Verbindung mit den zugeordneten Korrekturwerten KT0n (Fig. 6F) vor. Dann werden zählergesteuert die Impulse I0n im Grob-Zeitraster (Fig. 6G) erzeugt und aufgrund der Korrekturwerte KT0n (Fig. 6F) und KI0n (Fig. 6H) durch eine entsprechend selektierte Zeitverzögerung TDnA/E (Fig. 6J) in Verbindung mit einer T0n-Korrektur (Fig. 6K) beim Auftreten eines Übertrages verzögert.

Bei der hierfür benutzten Schaltung (Fig. 5 und Fig. 7) ist es wesentlich, dass die Quarzgenauigkeit sämtlicher Schaltungsfunktionen bis hin zur programmierbaren Feinverzögerung 515 erhalten bleibt.

Wenn sich das gewählte Ausführungsbeispiel auch auf eine 100-Picosekunden-Zeitauflösung bezieht, so ist es dennoch möglich, mit Hilfe der heute zur Verfügung stehenden Bauelemente unter Beibehaltung der 100-MHz-Quarzoszillator-Basisfrequenz eine Zeitauflösung von 10 Picosekunden zu erreichen.

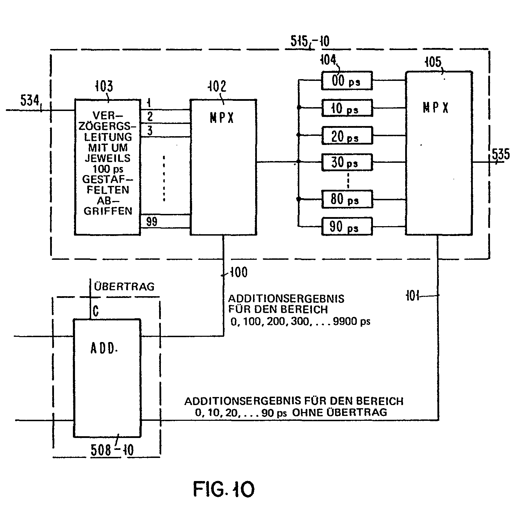

Zu diesem Zweck wären lediglich die Korrekturwerte KT0n und KI0n für diese Zeitauflösung vorzugeben und die programmierbare Verzögerung 515 in Fig. 5 gemäss Fig. 9 für eine 10-Picosekunden-Auflösung zu modifizieren. Eine solche Modifizierung ist in Fig. 10 gezeigt. Der Addierer 508 stellt das Summenergebnis (ohne Übertrag) auf zwei Leitungen 100 und 101 zur Verfügung. Leitung 101 führt die Zeitwerte von 10 bis 90 Picosekunden, die Leitung 100 die Zeitwerte grösser als 90 Picosekunden. Die Leitung 100 führt zu einer Multiplex-Schaltung 102 zur Auswahl eines Verzögerungsleitungsabgriffes (von 99) einer Verzögerungsleitung 103 mit um 100 Picosekunden gestaffelten Verzögerungsleitungsabgriffen 1–99.

Der Ausgang der Multiplex-Schaltung 102 führt zu einem Bündel 104 von Verzögerungsleitungen mit um jeweils 10 Picosekunden gestaffelten Verzögerungswerten. Die Ausgänge dieser Verzögerungsleitungen sind der Multiplex-Leitung 105 zugeführt, die in Abhängigkeit von dem auf der Leitung 101 anstehenden Steuerwert den Ausgang einer dieser Verzögerungsleitungen durchschaltet. Auf diese Weise unterliegt ein Verzögerungszeitwert von insgesamt 140 Picosekunden einer Aufspaltung in 100 Picosekunden für die Verzögerungsleitung 103 und in 40 Picosekunden für das Verzögerungsleitungsbündel 104.

Die z.Zt. im Handel verfügbaren Verzögerungsleitungen mit einer 100-Picosekunden-Staffelung ihrer Abgriffe eignen sich jedoch wie bereits erwähnt nur zur Verzögerung einmaliger Spannungssprünge (und nicht zur Verzögerung periodischer Impulsraster im 100-MHz-Bereich). Auch wenn die Genauigkeit ihrer Abgriffe grössere Toleranzen aufweisen, lassen sie sich vorteilhaft zur Feinverzögerung bei der Erzeugung der Impulse einsetzen. Dies hat im einzelnen folgende Gründe:

Wenn der Beginn eines Impulses z.B. I2AT = 39,9 Nanosekunden nach Beginn eines Grob-Impulsintervalles liegt, so ist der auftretende durch die Toleranz der Feinverzögerungsleitung bedingte Fehler in Relation zu den Nanosekunden dieses Wertes relativ klein. Des weiteren lässt sich dieser Fehler durch eine modifizierte Vorgabe des Wertes I2AT zumindest ausgleichen.

Bei den Toleranzangaben für die Feinverzögerungsleitung ist davon auszugehen, dass in der aufsteigenden Reihenfolge der Verzögerungsleitungsabgriffe deren absolute Verzögerungswerte ständig ansteigen.

Bei dem bekannten System (Fig. 3) kommen zur Toleranz der Verzögerungsleitungen in der Schaltung 305 bzw. 309 stets die Toleranzen der Verzögerungsleitungen 302 bzw. 307 hinzu. Letztere bedingen eine Verschiebung der Impulsintervallanfänge, auf die jedoch die Impulserzeugung bezogen wird. Eine derartige Kettung von Toleranzen tritt bei dem erfindungsgemässen neuen System nicht mehr auf, da es «quarzgenau» arbeitet und erst am Ende des Systems eine durch die Verzögerung 515 bedingte Toleranz in Kauf zu nehmen ist.

Im folgenden wird eine Übersicht zu den Vor- und Nachteilen des in der Deutschen Patentanmeldung OS 3 023 699 (GE 979 042) beschriebenen Systems (im folgenden altes System genannt) zur Erzeugung von Impulsen vorgegebener Zeitrelation innerhalb vorgegebener Impulsintervalle mit hoher zeitlicher Auflösung und dem erfindungsgemässen in dieser Anmeldung beschriebenen System (im folgenden neues System genannt) gegeben.

Dabei wird beispielsweise wieder davon ausgegangen, dass beide Systeme auf einem 100-MHz-Quarzoszillator zur Vorgabe eines 10-Nanosekunden-Grob-Zeitrasters basieren. Es sei jedoch bereits an dieser Stelle bemerkt, dass die Verwendung von Oszillatoren mit einer niederen oder höheren Frequenz in Abhängigkeit von der Schnelligkeit der zur Verfügung stehenden Schaltkreise ebensogut möglich ist.

1. Die erreichbare kleinste Impulsintervall-Länge

Nach dem alten System war dieser Grösse eine schaltungstechnische Grenze gesetzt, die durch das Umschalten der Basisfrequenz (1000 MHz) an den Verzögerungsleitungsabgriffen bedingt war. Je nach der verwendeten Schaltkreistechnologie waren kleinste Soll-Impulsintervallzeiten von beispielsweise 50, bzw. 30 Nanosekunden erforderlich und erreichbar.

Nach dem neuen System entfällt das Umschalten der Basisfrequenz, so dass die erreichbare kleinste Impulsintervalldauer lediglich durch die ohnehin grosse Schnelligkeit der verwendeten Schaltkreise begrenzt ist und bei ca. 10 Nanosekunden liegt.

## 2. Zeitliches Auflösungsvermögen des Impulsintervalles

Nach dem alten System war diese Grösse durch die Zeit-Staffelung der Verzögerungsleitungsabgriffe bedingt. Eine Auflösung von 1 Nanosekunde war aber bereits mit einem enormen Abgleichaufwand verbunden und nicht beliebig zu steigern. Das Auflösungsvermögen für das alte System beträgt je nach Schaltkreistechnologie 1–5 Nanosekunden.

Nach dem neuen System unterliegt die zeitliche Auflösung des Impulsintervalles nicht dieser schaltungstechnischen Grenze.

Die zeitliche Auflösung der Impulsintervalle für das neue System liegt lediglich die willkürliche Vorgabe von Fein-Zeitrasterwerten für einen Korrekturaddierer (709 in Fig. 7) zugrunde. Wenn sich diese Korrekturwerte auf 100-Picosekunden-Zeitraster beziehen, liegt somit die zeitliche Auflösung für die Impulsintervalle bei 100 Picosekunden und ist damit um den Faktor 10 höher als beim alten System.

## 3. Zeitliches Auflösungsvermögen der Impulse

Beim alten System liess die Schnelligkeit (insbesondere der Zähler für eine 10-Nanosekunden-Zählrate) der verfügbaren Schaltkreise kein höheres Auflösungsvermögen als 1 Nanosekunde zu.

Beim neuen System ist das zeitliche Auflösungsvermögen lediglich durch die Zeitstaffelung der Abgriffe einer der Additions-Korrektur-Schaltung nachgeschalteten «Fein»-Verzögerungsleitung bestimmt. Verzögerungsleitungen mit einer zeitlichen Feinstaffelung ihrer Abgriffe für ein 100-Picosekunden-Zeitraster sind heute bereits im Handel verfügbar. Die zeitliche Auflösung des Impulsintervalles für das neue System liegt bei 100 Picosekunden und ist damit um den Faktor 10 höher als beim alten System.

Es sei jedoch in diesem Zusammenhang darauf hingewiesen, dass es nach dem neuen System unter Verwendung verfügbarer Schaltkreiselemente auch möglich ist, eine zeitliche Auflösung der Impulsintervalle im 50-Picosekunden- und auch 10-Picosekunden-Bereich (s. Fig. 10) zu erreichen.

## 4. Impulslänge

Die maximale Impulslänge beim alten System beträgt 2× Impulsintervall-Länge minus «Wartezeit» der umzuschaltenden Basisfrequenz an der Verzögerungsleitung (die Einschwingzeit liegt in der Grössenordnung von 20 bis 30 Nanosekunden). Auf diese Weise hat die Impulslänge bei dem alten System eine obere Grenze. Nach dem neuen System ist die Impulslänge keine obere Grenze gesetzt, da kein Umschalten der Basisfrequenz erfolgt und entsprechende Korrekturwerte zur Vorgabe der Impulslänge beliebig gross sein und beliebig lange gespeichert bleiben können.

## 5. Genauigkeit

Sowohl beim alten als auch beim neuen System ist die Wiederholgenauigkeit der zu erzeugenden Impulse von der Genauigkeit des Quarzoszillators abhängig. Aus diesem Grunde wird die Wiederholgenauigkeit auch als quarzstabil bezeichnet. Bei handelsüblichen 100-MHz-Quarzen liegt die Frequenzgenauigkeit bei 0,1 ppm (Part per Million).

In die absolute Genauigkeit beim alten System geht neben der Quarzoszillatorabweichung (vernachlässigbar) die Justage-Abweichung der Verzögerungsleitungen zum Umschalten der Basisfrequenz, die Genauigkeit der Zwei-Weg-Justage 310 (Fig. 3), die Toleranz der verwendeten Verzögerungsleitungen zur Impulserzeugung und der Temperaturgang der Gesamtschaltung ein.

Beim neuen System ist die absolute Genauigkeit, abgesehen von der vernachlässigbaren Abweichung des Quarzoszillators nur von der Toleranz der verwendeten Fein-Verzögerungsleitung 515 (Fig. 5) für die Impulserzeugung und von der Temperaturabhängigkeit nur dieser Verzögerungsleitung (und nicht der Gesamtschaltung) abhängig. Dies ist einleuchtend, da der 100-MHz-Oszillator direkt auf diese Verzögerungsleitung (ohne Zwischenschaltung irgendwelcher Schaltungsgruppen wie beim alten System) arbeitet.

Bekannte auf analoger Basis arbeitende Anordnungen zur Erzeugung von innerhalb von Impulsintervallen liegenden Impulsen mit variierbaren Zeitrelationen weisen den grossen Nachteil eines sogenannten prozentualen Fehlers auf. Bei Anordnungen dieser Art wird eine annähernd linear ansteigende Spannung mit einer Vergleichsspannung verglichen. Zum Zeitpunkt der Gleichheit beider Werte wird eine Impulsflanke erzeugt. Die Zeit, die vom Beginn des Ansteigens der linearen Spannung bis zur Erzeugung der Impulsflanke vergeht, ist mit dem sogenannten prozentualen Fehler behaftet. Für kleine Zeitwerte ist er selbstverständlich kleiner als für grössere Zeitwerte. Dies macht jedoch diese Anordnungen, besonders wenn es sich um die Genauigkeit grosser Zeitwerte handelt, sehr ungenau. Prozentuale Fehler dieser Art treten beim erfindungsgemässen neuen System jedoch nicht auf, da unabhängig von der Vorgabe der Grösse der Zeitwerte dieselben lediglich mit der von diesen Zeitwerten unabhängigen Quarzgenauigkeit und der konstanten Toleranz der Feinverzögerung abhängt.

Es wurde bereits darauf hingewiesen, dass das erfindungsgemässe Verfahren bzw. die erfindungsgemässe Anordnung zur Durchführung des Verfahrens insbesondere zum Austesten sehr schneller Speicherprodukte und logischer Schaltungen eingesetzt werden können. Darüberhinaus bietet sich jedoch wie bereits in der DE-A-2 829 709 erwähnt eine Vielzahl anderer Anwendungsmöglichkeiten, z.B. die Tastung von Sendefrequenzen oder die Erzeugung entsprechend vorzugebender Frequenzen sowohl im niederen Frequenzbereich (hörbarer Tonbereich) als auch im sehr hohen MHz-Bereich. Dabei ist es wesentlich, dass Trägerfrequenzen (Sendefrequenzen) programmierbar umgeschaltet werden können oder Tonfrequenzen ohne Einschwingvorgänge nahtlos umzuschalten.

Die Aufzählung dieser Anwendungen ist selbstverständlich nicht allumfassend. Allgemein kann gesagt werden, dass das erfindungsgemässe Verfahren und die zur Durchführung dieses Verfahrens bestimmte Anordnung überall dort angewendet werden kann, wo es um die Erzeugung beliebiger Impulsmuster mit höchster zeitlicher Auflösung geht und wobei die Vorgabe der Werte für die Impulsintervalldauer bzw. der Impulsdauer keinen Beschränkungen unterliegt.

**Patentansprüche**

1. Verfahren zur totzeitlosen Erzeugung von in vorgegebenen aufeinanderfolgenden Soll-Impulsintervallen (Fig. 6A: T1, TZ2, T3, ... Tn) auftretenden Soll-Impulsen (Fig. 6D: I1, I2, I3, ...) mit sehr hoher zeitlicher Auflösung unter digitaler Vorgabe der Zeitwerte für die Dauer der Soll-Impulsintervalle und der auf den Beginn der Soll-Impulsintervalle bezogenen Zeitwerte (I1A, I1E; I2A, I2E; I3A, I3E; ...) für den Beginn und das Ende der Soll-Impulse, deren Flanken für ein Grob-Zeitraster zählergesteuert und für ein Fein-Zeitraster verzögerungsgesteuert abgeleitet werden, dadurch gekennzeichnet,

a) dass die Zeitwerte in ein Grob-Zeitraster und ein Fein-Zeitraster aufgeteilt werden,

b) dass aus den vorgegebenen Soll-Impulsintervallen (Fig. 6A) lückenlos einander anschliessende Grob-Impulsintervalle (Fig. 6E: T01, T02, T03, ...) im Grobzeitraster mit zugehörigen Grob-Impulsintervall-Korrekturwerten (Fig. 6F: KT01, KT02, KT03, ...) im Fein-Zeitraster in der Weise erzeugt werden,

dass die Grob-Impulsintervall-Zeitwerte und die dazugehörigen Grob-Impulsintervall-Korrekturwerte prozessorgesteuert in der zeitlichen Reihenfolge ihres Auftretens aus in einem Speicher vorgegebenen Grob-Soll-Impulsintervall-Zeitwerten (TnG, Fig. 6B) im Grob-Zeitraster und den ihnen zugeordneten Korrekturwerten (KTnG, Fig. 6C) im Fein-Zeitraster zusammengesetzt werden,

so dass für aufeinanderfolgende Soll-Impulsintervalle (Tn) die Summe der kumulativen Addition der Grob-Impulsintervall-Dauer zu dem zugehörigen Grob-Impulsintervall-Korrekturwert die Soll-Impulsintervall-Dauer ist,

c) dass aus den vorgegebenen Zeitwerten der Soll-Impulse Grob-Impulse (Fig. 6G: I01, I02, I03, ...) im Grob-Zeitraster mit zugehörigen Grob-Impuls-Korrekturwerten (Fig. 6H) im Fein-Zeitraster erzeugt werden,

wobei die Zeitwerte für den Beginn (Fig. 6G: I01A, I02A, I03A, ...) und das Ende (Fig. 6G: I01E, I02E, I03E, ...) der Grob-Impulse auf den Beginn des ihnen jeweils zugeordneten Grob-Impulsintervalles bezogen sind und

jedem Grob-Impuls-Beginn und Grob-Impuls-Ende ein Grob-Impuls-Korrekturwert (Fig. 6H: KT01A, KT01E; KT02A, KT03A, KT03E, ...) zugeordnet wird,

so dass die Summe der Addition des Zeitwertes für den Grob-Impuls-Beginn bzw. für das Grob-Impuls-Ende zu dem entsprechend zugehörigen Grob-Impuls-Korrekturwert der auf den Beginn des Soll-Impulsintervalls bezogene Zeitwert für den Soll-Impuls-Beginn bzw. das Soll-Impuls-Ende ist (z.B. I01A + KT01A = I1A; ...; I03E + KI04B = I3E)

dass die Anfang und Ende der Grob-Impulse (I0n, Fig. 6G) im Grob-Zeitraster kennzeichnenden auf den Beginn der zugeordneten Grob-Impulsintervalle (T0n) im Grob-Zeitraster (Fig. 6E) bezogenen Zeitwerte (I0nE, Fig. 6G) und die zugehörigen Korrekturwerte (KI0nA bzw. KI0nE) im Feinzeitraster (Fig. 6H) durch einen prozessorgesteuerten Speicher vorgegeben werden,

d) dass durch jeweilige Addition des Grob-Impulsintervall-Korrekturwertes (Fig. 6F) zu dem Grob-Impuls-Korrekturwert (Fig. 6H) für den Beginn bzw. das Ende des Grob-Impulses ein Summenkorrekturwert (Fig. 6I: SK1A, SK1E; SK2A, SK2E; SK3A, SK3E; ...) gebildet wird,

e) dass der Summenkorrekturwert in einen ersten (Fig. 6J: TD1A, TD1E; TD2A, TD2E; TD3A, TD3E; ...), dem Fein-Zeitraster und gegebenenfalls einen zweiten (Fig. 6K), dem Grob-Zeitraster zugeordneten Teil aufgegliedert wird,

f) dass beim Vorliegen des zweiten Teiles des Summenkorrekturwertes die Grob-Impuls-Flanke um das diesem Teil entsprechenden Grob-Zeitraster verschoben wird (Übertrag),

g) dass der erste Teil des Summenkorrekturwertes als Steuerwert für eine selektierte Zeitverzögerung für die gemäss Schritt f) verschobene oder im Falle des Fehlens des zweiten Teiles des Summenkorrekturwertes nicht verschobene Grob-Impuls-Flanke verwendet wird,

h) dass das Grobzeitraster von einer frequenzstabilen Signalquelle abgeleitet wird.

2. Verfahren nach Anspruch 1, dadurch gekennzeichnet, dass die Erzeugung der Grob-Impulsintervalle (Fig. 6E) dadurch erfolgt,

dass von einem durch das Grob-Zeitraster zähltaktbetriebenen und aus einem Speicher mit einem der Grob-Soll-Impulsintervalldauer (TnG, Fig. 6B) entsprechenden Ausgangszählwert ladbaren Abwärtszähler (702) bei Erreichung eines bestimmten Zählerstandes die Erzeugung eines den Grob-Impulsintervall-Beginn kennzeichnenden Signales abgeleitet wird,

und bei dem vor Erreichung dieses bestimmten Zählerstandes das Laden des Abwärtszählers mit einem neuen Zählerausgangswert aus dem Speicher eingeleitet und zu einem Zeitpunkt vollzogen wird, an dem der Abwärtszähler für den vorausgehenden Zählvorgang den Zählerstand 0 erreicht,

und dass der Beginn eines Abwärtszählvorganges des Abwärtszählers (702) um mindestens einen Zähltakt verzögert wird, wenn sich bei einem Additionsvorgang ein Übertrag ergibt, wobei sich die Addition auf den vom Speicher ge-

lieferten Grob-Soll-Impulsintervall-Korrektur-wert (Fig. 6C) für das aktuelle Impulsintervall und das Additionsergebnis ohne Übertrag für das dem aktuellen vorausgehende Impulsintervall bezieht,

und dass der Grob-Impulsintervall-Korrekturwert für das aktuelle Impulsintervall von dem Additionsergebnis ohne Übertrag für das aktuelle Impulsintervall gebildet wird.

3. Verfahren nach einem der Ansprüche 1 oder 2, gekennzeichnet durch die Anwendung zum Austesten schneller Speicherprodukte oder schneller logischer Schaltungen.

4. Verfahren nach einem der Ansprüche 1 oder 2, dadurch gekennzeichnet,

dass in an sich bekannter Weise die Soll-Impulse zur Tastung von gleichen oder unterschiedlichen Frequenzen benutzt werden.

5. Verfahren nach einem der Ansprüche 1 oder 2, dadurch gekennzeichnet,

dass sich der zu erzeugende Soll-Impuls von einem Soll-Impulsintervall bis in ein beliebiges anderes Soll-Impulsintervall fortsetzt.

6. Anordnung durch Durchführung des Verfahrens nach Anspruch 1, dadurch gekennzeichnet,

dass eine Schaltung (Fig. 4) zur Erzeugung von den Beginn der Grob-Impulsintervalle (TOn, Fig. 6E) kennzeichnenden Signalen und der zugehörigen digitalen Grob-Impulsintervall-Korrekturwerte (KTOn, Fig. 6F) vorgesehen ist, und dass ein prozessorgesteuerter Speicher (501) zur Vorgabe der Anfang bzw. Ende der Grob-Impulse (IOn, Fig. 6G) im Grob-Zeitraster kennzeichnenden auf den Beginn der zugeordneten Grob-Impulsintervalle, (TOn) im Grob-Zeitraster (Fig. 6E) bezogenen Zeitwerte (IOnA bzw. IOnE, Fig. 6G) und der zugehörigen Korrekturwerte (KIOnA bzw. KIOnE) im Fein-Zeitraster (Fig. 6H) und eines Startsteuerbits für jedes Grob-Impulsintervall (TOn) vorgesehen ist,

dass ein Quarzoszillator (1) zur Ableitung einer Grob-Zeitraster-Impulsfolge vorgesehen ist, dass mit dem Auftreten eines den Beginn eines Grob-Impulsintervalles (TOn) anzeigenden Signales das Startsteuerbit einer Start-Steuerung (502) zuführbar ist,

dass der für die voneinander getrennt erfolgende Erzeugung der Anstiegsflanke bzw. Abfallflanke des Soll-Impulses (In, Fig. 6D),

ein mit dem Zeitwert für den Grob-Impuls-Beginn (IOnA) bzw. für das Grob-Impuls-Ende (IOnE) ladbarer, mit der Grob-Zeitraster-Impulsfolge getakteter und durch die Start-Steuerung (502) startbarer erster Abwärtszähler (503) und ein erster Detektor (504) vorgesehen ist, durch den nach einem Abwärtszähllauf bis zu einem bestimmten Wert ein Impulsflankensignal erzeugbar ist, dass ein erster Addierer (508) vorgesehen ist zur Addition der Korrekturwerte (KIOnA bzw. KIOnE und KTOn), wobei das Additionsergebnis gegebenenfalls in einen Übertrag für den ersten Addierer und in einen Summenwert ohne Übertrag für den ersten Addierer aufgegliedert ist,

dass der Übertrag für den ersten Addierer einer Schaltung (Fig. 5, Teil B) zuführbar ist, durch die eine Verschiebung des Impulsflankensignales um einen diesem Übertrag entsprechenden Grob-Zeitrasterwert bewirkbar ist,

dass das unverschobene bzw. beim Auftreten eines Übertrages verschobene Impulsflankensignal einer durch den Summenwert ohne Übertrag für den ersten Addierer steuerbaren Verzögerungsschaltung (515) zuführbar ist zur Erzeugung der Soll-Impuls-Anstiegs- bzw. -Abfallflanke und

dass die Soll-Impuls-Anstiegs- und -Abfallflanke einer bistabilen Kippschaltung (536) zur Erzeugung des Soll-Impulses in (Fig. 6D) zuführbar sind, wobei n = 1, 2, 3, ... ist.

7. Anordnung nach Anspruch 6 zur Durchführung des Verfahrens nach Anspruch 1, dadurch gekennzeichnet,

dass der prozessorgesteuerte Speicher (501) auch zur Vorgabe der Werte für die Zeitdauer der Grob-Soll-Impulsintervalle (TnG) im Grob-Zeitraster (Fig. 6B) und der zugehörigen Korrekturwerte (KTnG) im Fein-Zeitraster (Fig. 6C) dient, wobei der Beginn jedes Grob-Soll-Impulsintervalles mit dem Beginn des zugeordneten Soll-Impulsintervalles (Fig. 6A) zusammenfällt,

dass zur Erzeugung der dem Beginn der Grob-Impulsintervalle (TOn) im Grob-Zeitraster kennzeichnenden Signale ein mit dem TnG-Wert ladbarer und mit der Grob-Zeitraster-Impulsfolge getakteter zweiter Abwärtszähler (702) und ein zweiter Detektor (704) vorgesehen ist,

der nach einem Abwärts-Zähllauf bis zu einem bestimmten Wert ein Signal (S) erzeugt,

und dass ein zweiter Addierer (712) für die Addition des Korrekturwertes (KTnG) des aktuellen Grob-Soll-Impulsintervalles (TnG) zu dem Addierergebnis ohne Übertrag für das vorausgehende Grob-Soll-Impulsintervall (T(n–1)G) vorgesehen ist, wobei das Additionsergebnis gegebenenfalls in einem ein in einen Übertrag für den zweiten Addierer und in einen Summenwert ohne Übertrag für den zweiten Addierer aufgegliedert ist,

dass der Übertrag für den zweiten Addierer einer Schaltung (705) zur Verschiebung des Signales (S) um einen diesem Übertrag entsprechenden Grob-Zeitrasterwert zuführbar ist,

dass das verschobene bzw. beim Auftreten eines Übertrages unverschobene Signal (S) den Beginn eines Grob-Impulsintervalles (TOn) im Grob-Zeitraster kennzeichnet und

dass der Summenwert ohne Übertrag für den zweiten Addierer als KTOn-Korrekturwert im Fein-Zeitraster für das Grob-Impulsintervall (TOn) vorgebbar ist

(n = 1, 2, 3, ...).

8. Anordnung nach Anspruch 7, dadurch gekennzeichnet,

dass die Schaltung (705) in an sich bekannter Weise den Zähltakt für den zweiten Abwärtszähler (702) um einen dem Übertrag entsprechenden Zählwert verzögert.

9. Anordnung nach Anspruch 6, dadurch gekennzeichnet, dass die Schaltung (Fig. 5, Teil B) zur Verschiebung des Impulsflankensignals um dem Übertrag entsprechenden Grob-Zeitrasterwert ein von der Grob-Zeitraster-Impulsfolge getaktetes und von einem dem Impulsflankensignal entsprechenden Eingangsignal beaufschlagtes Schieberegister (509) aus hintereinander geschalteten Stufen enthält, an denen das um jeweils ein Grob-Zeitraster verzögerte Impulsflankensignal abnehmbar ist,

dass das unverzögerte oder im Falle des Auftretens eines Übertrags verzögerte Impulsflankensignal jeweils einem ersten und zweiten UND-Glied (510, 511) zuführbar ist,

dass der zweite Eingang des ersten UND-Gliedes (510) mit einem negierten und der zweite Eingang des zweiten UND-Gliedes (511) mit einem unnegierten den Übertrag kennzeichnenden Signal beaufschlagbar ist und

dass die Ausgänge beider UND-Glieder (510 und 511) über ein ODER-Glied (513) vereinigt sind.

10. Anordnung nach Anspruch 6, dadurch gekennzeichnet,

dass die steuerbare Verzögerungsschaltung (515) eine Verzögerungsleitung mit Abgriffen für unterschiedliche Verzögerungswerte im Fein-Zeitraster ist und

dass eine Multiplex-Steuerschaltung (539) vorgesehen sit zur selektiven Auswahl eines dieser Abgriffe entsprechend dem Summenwert ohne Übertrag für den ersten Addierer.

11. Anordnung nach Anspruch 6, dadurch gekennzeichnet,

dass die steuerbare Verzögerungsschaltung (515) aus der Hintereinanderschaltung einer ersten (103) und einer zweiten (104) Verzögerungsleitung jeweils mit Abgriffen für unterschiedliche Verzögerungswerte ist,

dass die Zeitstaffelung der ersten Verzögerungsleitung (103) grösser ist als die Gesamtverzögerung der zweiten Verzögerungsleitung (104) und dass der Summenwert ohne Übertrag für den ersten Addierer in zwei Steuerwerte für beide Multiplex-Steuerschaltungen (102 bzw. 105) aufgeteilt wird.

## Claims

1. Method of generating desired pulses (Fig. 6D: I1, I2, I3, ...) with a very high time resolution and without dead times within successive desired pulse intervals (Fig. 6A: T1, T2, T3, ... Tn) by digitally predetermining the time values for the duration of the desired pulse intervals and the time values (I1A, I1E; I2A, I2E; I3A, I3E; ...), related to the start of the desired pulse intervals, for the start and the end of the desired pulses, whose edges for a coarse and a fine time raster are derived respectively under counter control and as a function of a delay, characterized in that

a) the time values are divided into a coarse and a fine time raster;

b) continuous, successive coarse pulse intervals (Fig. 6E: T01, T02, T03, ...) in the coarse time raster along with the associated coarse pulse interval correction values (Fig. 6F: KT01, KT02, KT03, ...) in the fine time raster are generated from the predetermined desired pulse intervals (Fig. 6A) in such a manner

that the coarse pulse interval time values and the associated coarse pulse interval correction values are formed under processor control in the time sequence of their occurrence from desired coarse pulse interval time values (TnG, Fig. 6B) in the coarse time raster stored in a memory and from associated correction values (KTnG, Fig. 6C) in the fine time raster such that for successive desired pulse intervals (Tn), the sum of the cumulative addition of the coarse pulse interval duration to the associated coarse pulse interval correction value is the desired pulse interval duration;

c) coarse pulses (fig. 6G) I01, I02, I03, ...) in the coarse time raster along with the associated coarse pulse correction values (Fig. 6H) in the fine time raster are generated from the predetermined time values of the desired pulses, the time values for the start (Fig. 6G: I01A, I02A, I03A, ...) and the end (Fig. 6G: I01E, I02E, I03E, ...) of the coarse pulses being related to the start of their associated coarse pulse interval, and each coarse pulse start and coarse pulse end being associated with a coarse pulse correction value (Fig. 6H: KT01A, KT01E; KT02A, KT02E; KT03A, KT03E, ...), so that the sum of the addition of the time value for the coarse pulse start and the coarse pulse end, respectively, to the associated coarse pulse correction value is the time value, related to the start of the desired pulse interval, for the desired pulse start and the desired pulse end, respectively (e.g., I01A + KT01A = I1A; ...; I03E + KI04B = I3E);

that the time values (I0nE, Fig. 6G), designating the start and the end of the coarse pulses (I0n, Fig. 6G) in the coarse time raster and related to the start of the associated coarse pulse intervals (T0n) in the coarse time raster (Fig. 6E), and the associated correction values (KI0nA and KI0nE, respectively) are predetermined in the fine time raster (Fig. 6H) by a processor-controlled memory;

d) by adding the coarse pulse interval correction value (Fig. 6F) to the coarse pulse correction value (Fig. 6H) for the start and the end, respectively, of the coarse pulse, a sum correction value (Fig. 6I: SK1A, SK1E; SK2A, SK2E; SK3A, SK3E; ...) is formed;

e) the sum correction value is divided into a first partial value (Fig. 6J: TD1A, TD1E; TD2A, TD2E; TD3A, TD3E; ...), associated with the fine time raster, and, if necessary, into a second partial value (Fig. 6K) associated with the coarse time raster;

f) in response to the second partial value of the sum correction value, the coarse pulse edge is shifted by the coarse time raster corresponding to this partial value (carry);

g) the first partial value of the sum correction value is used as a control value for a selected time delay for the coarse pulse edge shifted according to step f), or, in the absence of the second partial value of the sum correction value, for the unshifted coarse pulse edge, and

h) the coarse time raster is derived from a frequency stable signal source.

2. Method according to claim 1,
characterized in that the generation of the coarse pulse intervals (Fig. 6E) is effected in
that after a particular count has been reached, a down counter (702), count clock driven by the coarse time raster and loadable with an initial count corresponding to the duration of the desired coarse pulse interval (TnG, Fig. 6B), causes a signal, designating the start of the coarse pulse interval, to be generated,
and wherein, before this particular count is reached, the loading of the down counter with a new initial value from memory is initiated and effected at a time at which the down counter reaches a 0 count for the preceding count step,
and that down counting of the down counter (702) is delayed by at least one count clock if a carry occurs in an addition step,
said addition step relating to the desired coarse pulse interval correction value (Fig. 6C), supplied form memory for the current pulse interval, and to the addition result without a carry for the pulse interval preceding the current pulse interval,
and that the coarse pulse interval correction value for the current pulse interval is generated from the addition result without a carry for the current pulse interval.

3. Method according to any one of the claims 1 or 2,
characterized in that it is used to test fast memory products or fast logic circuits.

4. Method according to any one of the claims 1 or 2,
characterized in that the desired pulses are used in a manner known per se to sample identical or different frequencies.

5. Method according to any one of the claims 1 or 2,
characterized in that the desired pulse to be generated extends from one desired pulse interval to an arbitrary other desired pulse interval.

6. Arrangement for implementing the method according to claim 1,
characterized in that a circuit (fig. 4) is provided for generating signals designating the start of the coarse pulse intervals (T0n, Fig. 6E) and the associated digital coarse pulse interval correction values (KT0n, Fig. 6G), and
that a processor-controlled memory (501) is provided for supplying time values (I0nA and I0nE, respectively, Fig. 6G), designating the start and/or the end of the coarse pulses (I0n, Fig. 6G) in the coarse time raster and relating to the start of the associated coarse pulse intervals (T0n) in the coarse time raster (Fig. 6E), and the associated correction values (KI0nA and KI0nE, respectively) in the fine time raster (Fig. 6H), as well as a start control bit for each coarse pulse interval (T0n),
that a quartz oscillator (1) is provided for deriving a coarse time raster pulse train,

that upon the occurrence of a signal designating the start of a coarse pulse interval (T0n), the start control bit is fed to a start control (502),
that for the leading and/or trailing edges of the desired pulse (In, Fig. 6D), which are generated separately of each other, a first down counter (503) and a first detector (504) are provided, said first down counter being loaded with the time value for the coarse pulse start (I0nA) and/or the coarse pulse end (I0nE), clocked with the coarse time raster pulse train, and started by the start control (502), and said first detector generating a pulse edge signal after a particular count has been reached during down counting,
that a first adder (508) is provided for adding the correction values (KI0nA and/or KI0nE and KT0n), the addition result being divided, if necessary, into a carry for the first adder and into a sum value without a carry for said first adder,
that the carry for said first adder is fed to a circuit (Fig. 5, part B) causing the pulse edge signal to be shifted by a coarse time raster value corresponding to said carry,
that the unshifted pulse edge signal and/or the pulse edge signal shifted in response to a carry is fed to a delay circuit (515) controlled by the sum value without a carry for said first adder and serving to respectively generate the desired pulse leading and trailing edge, and
that the desired pulse leading and trailing edges are fed to a flip-flop (536) for generating the desired pulse In (Fig. 6D), where n = 1, 2, 3, ... .

7. Arrangement according to claim 6 for implementing the method according to claim 1,
characterized in
that the processor-controlled memory (501) also serves to supply the values for the duration of the desired coarse pulse intervals (TnG) in the coarse time raster (Fig. 6B) and the associated correction values (KTnG) in the fine time raster (Fig. 6C), the start of each desired coarse pulse interval coinciding with the start of the associated desired pulse interval (Fig. 6A),
that for generating the signals designating the start of the coarse pulse intervals (T0n) in the coarse time raster, a second down counter (702), loadable with the TnG value and clocked by the coarse time pulse train, and a second detector (704) are provided,
said second detector generating a signal (S) after a particular count has been reached during down counting,
and that a second adder (712) is provided for adding the correction value (KTnG) of the current desired coarse pulse interval (TnG) to the addition result without carry for the preceding desired coarse pulse interval (T(n−1)G), the addition result being divided, if necessary, into a carry for the second adder and into a sum value without a carry for the second adder,
that the carry for said second adder is fed to a circuit (705) for shifting the signal (S) by a coarse time raster value corresponding to said carry,
that the shifted signal (S) or the signal (S) remaining unshifted as a result of a carry designates the start of a coarse pulse interval (T0n) in the coarse time raster, and

that the sum value without a carry for said second adder is provided as a KT0n correction value in the fine time raster for the coarse pulse interval (T0n) (n = 1, 2, 3, ...).

8. Arrangement according to claim 7, characterized in that the circuit (705) delays the count clock for said second down counter (702) in a manner known per se by a count corresponding to the carry.

9. Arrangement according to claim 6, characterized in that the circuit (Fig. 5, part B) for shifting the pulse edge signal by the coarse time raster value corresponding to the carry, comprises a shift register (509) clocked by the coarse time raster pulse train and receiving an input signal corresponding to the pulse edge signal, said shift register being made up of series-connected stages at which the pulse edge signal delayed by a coarse time raster is tapped,

that the undelayed pulse edge signal or the pulse edge signal delayed in response to a carry is fed to a first and a second AND gate (510, 511), that the second input of said first AND gate (510) receives an inverted signal and the second input of said second AND gate (511) an uninverted signal designating the carry, and

that the outputs of the two AND gates (510 and 511) are combined by an OR gate (513).

10. Arrangement according to claim 6, characterized in that the controllable delay circuit (515) is a delay line with taps for different delay values in the fine time raster, and

that a multiplex control circuit (539) is provided for selecting one of said taps according to the sum value without a carry for said first adder.

11. Arrangement according to claim 6, characterized in that the controllable delay circuit (515) consists of series-connected first (103) and second (104) delay lines, each having taps for different delay values,

that the time stagger of the first delay line (103) exceeds the total delay of the second delay line (104), and

that the sum value without a carry for said first adder is divided into two control values for the two multiplex control circuits (102 and 105, respectively).

## Revendications

1. Procédé pour produire, sans aucun temps mort et avec une résolution très élevée dans le temps, des impulsions de consigne (fig. 6D: I1, I2, I3, ...), qui apparaissent dans des intervalles à impulsions de consigne successifs prédéter – minés (fig. 6A: T1, T2, T3, ... Tn) moyennant la prédétermination numérique des valeurs temporelles pour la durée des intervalles à impulsions de consigne, et des valeurs temporelles (I1A, I1E; I2A, I2E; I3A, I3E; ...), rapportées au début des intervalles à impulsions de consigne pour le début et la fin des impulsions de consigne, dont les flancs sont obtenus d'une manière commandée par un compteur pour une trame temporelle étendue et d'une manière commandée avec un retard pour une trame temporelle étroite, caractérisé en ce

a) que les valeurs temporelles sont réparties dans une trame temporelle étendue et dans une trame temporelle étroite,

b) qu'à partir des intervalles prédéterminés à impulsions de consigne (fig. 6A), on produit des intervalles étendus à impulsions (fig. 6E: T01, T02, T03, ...), qui se succèdent sans discontinuité, dans la trame temporelle étendue avec des valeurs associées de correction des intervalles étendus à impulsions (fig. 6F: KT01, KT02, KT03, ...) dans la trame temporelle étroite de telle sorte que les valeurs temporelles des intervalles à impulsions étendus et les valeurs de correction associées des intervalles à impulsions étendu sont formées par réunion, commandée par un microprocesseur et selon la séquence temporelle de leur apparition, par des valeurs temporelles (TnG, figure 6B) d'intervalles étendus de consigne à impulsions, prédéterminées dans une mémoire et situées dans la trame temporelle étendue, et par des valeurs de correction (KTnG, fig. 6C), qui leur sont associées, dans la trame temporelle étroite, de sorte que pour des intervalles à impulsions de consigne successifs (Tn), la somme fournie par l'addition cumulée de la durée des intervalles à impulsions étendus et de la valeur de correction associée de l'intervalle étendu à impulsions est la durée de l'intervalle à impulsions de consigne,

c) qu'on forme, à partir des valeurs temporelles prédéterminées des impulsions de consigne, des impulsions étendues (fig. 6G: I01, I02, I03, ...) dans la trame temporelle étendue avec des valeurs de correction associées des impulsions étendues (fig. 6H) dans la trame temporelle étroite, les valeurs temporelles pour le début (fig. 6G: I01A, I02A, I03A, ...) et la fin (fig. 6G: I01E, I02E, I03E, ...) des impulsions étendues étant rapportées au début de l'intervalle étendu à impulsions, qui leur est respectivement associé, et une valeur de correction d'impulsion étendue (fig. 6H: KT01A, KT01E; KT02A, KT02E; KT03A, KT03E; ...) étant associée à chaque début d'impulsion étendue et à chaque fin d'impulsion étendue,

de telle sorte que la somme fournie par l'addition de la valeur temporelle pour le début de l'impulsion étendue et pour la fin de l'impulsion étendue et de la valeur de correction d'impulsion étendue, associée de façon correspondante, constitue la valeur temporelle, rapportée au début de l'intervalle à impulsions de consigne, pour le début de l'impulsion de consigne et pour la fin de l'impulsion de consigne (par exemple I01A+KT01A = I1A; ...; I03E+KI04B = I3E), les valeurs temporelles (I0nE, fig. 6G), qui caractérisent le début et la fin des impulsions étendues (I0n, fig. 6G) dans la trame temporelle étendue et qui sont rapportées au début des intervalles étendus à impulsions associés (T0n) dans la trame temporelle étendue (fig. 6E), et les valeurs de correction associées (KI0nA ou KI0nE) dans la trame temporel-

le étroite (fig. 6H) sont prédéterminées par une mémoire commandée par un processeur,

d) qu'on obtient une valeur de correction somme (fig. 6I: SK1A, SK1E; SK2A, SK2E; SK3A, SK3E; ...) au moyen de l'addition respective de la valeur de correction de l'intervalle à impulsions étendus (fig. 6E) et de la valeur de correction de l'impulsion étendue (fig. 6H),

e) que la valeur de correction somme est subdivisée en une première partie (fig. 6J: TD1A, TD1E; TD2A, TD2E; TD3A, TD3E; ...) associée à la trame temporelle étroite et éventuellement en une seconde partie (fig. 6A) associée à la trame temporelle étendue,

f) que dans le cas de la présence de la seconde partie de la valeur de correction somme, le flanc de l'impulsion étendue est décalé (transfert), de la valeur de la trame temporelle étendue correspondant à cette partie,

g) que la première partie de la valeur de correction somme est utilisée en tant que valeur de commande pour un retard temporel sélectionné pour le flanc de l'impulsion étendue, décalé conformément au pas f) ou bien pour le flanc de l'impulsion étendue, non décalé dans le cas de l'absence de la seconde partie de la valeur de correction somme,

h) que la trame temporelle étendue est obtenue à partir d'une source de signaux stable en fréquence.

2. Procédé selon la revendication 1, caractérisé en ce que la production des intervalles à impulsions étendus (fig. 6E) s'effectue grâce au fait que la production d'un signal caractérisant le début de l'intervalle à impulsions étendu est obtenue d'un compteur régressif (702), qui est commandé par la trame temporelle étendue, d'une manière cadencée pour le comptage, et peut être chargé à partir d'une mémoire avec une valeur de comptage de sortie correspondant à la durée de l'intervalle étendu de consigne à impulsions (TnG, fig. 6B) lorsqu'un état de comptage déterminé est atteint,

et dans lequel avant que soit atteint cet état de comptage déterminé le chargement du compteur régressif avec une nouvelle valeur de sortie du compteur fournie par la mémoire est déclenché et est achevé à un instant auquel le compteur régressif a atteint l'état de comptage 0 pour le processus précédent de comptage,

et que le début d'un processus de comptage régressif du compteur régressif (702) est retardé d'au moins un intervalle de cadence de comptage lorsqu'un report est réalisé lors d'une opération d'addition,

auquel cas l'addition concerne la valeur de correction (fig. 6C) de l'intervalle étendu de consigne à impulsions, délivrée par la mémoire, pour l'intervalle actuel à impulsions et le résultat de l'addition sans report pour l'intervalle à impulsions précédent,

et que la valeur de correction de l'intervalle à impulsions étendu est formée pour l'intervalle à impulsions actuel par le résultat de l'addition sans report pour l'intervalle à impulsions actuel.

3. Procédé selon l'une des revendications 1 ou 2, caractérisé par son application au contrôle d'articles en forme de mémoires rapides ou de circuits logiques rapides.

4. Procédé selon l'une des revendications 1 ou 2, caractérisé en ce que l'on utilise, de façon connue en soi, les impulsions de consigne pour la manipulation de fréquences identiques ou différentes.

5. Procédé selon l'une des revendications 1 ou 2, caractérisé en ce que l'impulsion de consigne devant être produite est prolongée par un intervalle à impulsions de consigne, jusque dans un autre intervalle à impulsions de consigne, quelconque.

6. Dispositif pour la mise en œuvre du procédé selon la revendication 1, caractérisé en ce qu'il est prévu un circuit (fig. 4) servant à produire des signaux caractérisant le début des intervalles à impulsions étendus (T0n, fig. 6E), et des valeurs numériques associées de correction d'intervalles à impulsions étendus (KT0n, fig. 6F), et

qu'il est prévu une mémoire (501) commandée par un processeur et servant à prédéterminer des valeurs temporelles (I0nA ou I0nE, fig. 6G), qui caractérisent le début et la fin des impulsions étendues (I0n, fig. 6G) dans la trame temporelle étendue et sont rapportées au début des intervalles à impulsions étendus associés (T0n) dans la trame temporelle étendue (fig. 6E), et aux valeurs de correction associées (KI0nA ou KI0nE) dans la trame temporelle étroite (fig. 6H) et un bit de commande de démarrage pour chaque intervalle à impulsions étendu (T0n),

qu'il est prévu un oscillateur à quartz (1) servant à délivrer une suite d'impulsions de trames temporelles étendues, que lors de l'apparition d'un signal indiquant le début d'un intervalle à impulsions étendu (T0n), le bit de commande de démarrage peut être envoyé à un dispositif de commande de démarrage (502),

que, pour la production, qui s'effectue de façon séparée, des flancs montants et des flancs descendant de l'impulsion de consigne (In, fig. 6D), il est prévu un premier compteur régressif (503), qui peut être chargé par la valeur temporelle pour le début de l'impulsion étendue (I0nA) et pour la fin de l'impulsion étendue (I0nE), et commandé de façon cadencée par la suite d'impulsions de trame temporelle étendue et qui peut être déclenché par le dispositif de commande de démarrage (502), et un premier détecteur (504), au moyen duquel un signal de flanc d'impulsions peut être produit après un comptage régressif jusqu'à une valeur déterminée,

qu'il est prévu un premier additionneur (508) servant à additionner les valeurs de correction (KI0nA ou KI0nE et KT0n), auquel cas le résultat de l'addition est subdivisé éventuellement en un report pour le premier additionneur et une valeur somme sans report pour le premier additionneur, que le report pour le premier additionneur peut être envoyé à un circuit (fig. 5, partie B), à l'aide duquel on peut obtenir un décalage du signal du flanc des impulsions, d'une valeur égale à une valeur de trame temporelle étendue correspondant à ce report,

que le signal de flanc d'impulsions, non décalé ou décalé lors de l'apparition d'un report, peut être envoyé à un circuit de retard (515) pouvant être commandé par la valeur somme sans report pour le premier additionneur, en vue d'obtenir la production du flanc montant ou du flanc descendant d'impulsions de consigne, et

que le flanc montant et le flanc descendant des impulsions de consigne peuvent être envoyés à un circuit à bascule bistable (536) pour produire l'impulsion de consigne ln (fig. 6D), auquel cas on a n = 1, 2, 3 ...

7. Dispositif selon la revendication 6, pour la mise en œuvre du procédé selon la revendication 1, caractérisé en ce

que la mémoire (501) commandée par un processeur sert également à prédéterminer les valeurs de la durée des intervalles étendus de consigne à impulsions (TnG) dans la trame temporelle étendue (fig. 6B) et les valeurs de correction associées (KTnG) dans la trame temporelle étroite (fig. 6C), auquel cas le début de chaque intervalle étendu de consigne à impulsions coïncide avec le début de l'intervalle de consigne associé à impulsions (fig. 6A),

que pour l'obtention des signaux caractérisant le début des intervalles étendus à impulsions (TOn) dans la trame temporelle étendue, il est prévu un second compteur régressif (702), qui peut être chargé par la valeur (TnG) et commandé de façon cadencée par la suite d'impulsions de trames temporelles étendues, et un second détecteur (704),

qui produit un signal (S) après un cycle de comptage régressif aboutissant à une valeur déterminée,

et qu'il est prévu un second additionneur (712) pour l'addition de la valeur de correction (KTnG) de l'intervalle étendu actuel de consigne à impulsions (TnG) au résultat de l'additionneur délivré sans report pour l'intervalle étendu précédent de consigne à impulsions (T(n–1)G), auquel cas le résultat de l'addition est éventuellement subdivisé en un report pour le second additionneur et en une valeur somme sans report pour le second additionneur,

que le report pour le second additionneur peut être envoyé à un circuit (705) servant à décaler le signal (S) d'une valeur égale à la valeur de trame temporelle étendue correspondant à ce report, que le signal (S) décalé ou non décalé lors de l'apparition d'un report caractérise le début d'un intervalle à impulsion étendu (TOn) dans la trame temporelle étendue, et

que la valeur somme sans report pour le second additionneur peut être prédéterminée en tant que valeur de correction (KTOn) dans la trame temporelle étroite pour l'intervalle à impulsion étendu (TOn) (n = 1, 2, 3, ...).

8. Dispositif selon la revendication 7, caractérisé en ce que le circuit (705) retarde de façon connue en soi la cadence de comptage pour le second compteur régressif (702), d'une valeur de comptage correspondant au report.

9. Dispositif selon la revendication 6, caractérisé en ce que le circuit (fig. 5, partie B) pour le décalage du signal du flanc des impulsions d'une valeur égale à la valeur de la trame temporelle étendue correspondant au report, contient un registre à décalage (509) commandé de façon cadencée par la suite d'impulsions de la trame temporelle étendue et chargé par un signal d'entrée correspondant au signal des flancs d'impulsions, à partir d'étages branchés en serie, au niveau desquels on peut prélever le signal de flanc d'impulsions retardé respectivement d'une trame temporelle étendue, que le signal de flanc d'impulsions non retardé ou bien retardé dans le cas de l'apparition d'un report peut être envoyé à des premier et second circuits ET (510, 511),

que la seconde entrée du premier circuit ET (510) peut être chargée avec un signal inversé et que la seconde entrée du second circuit ET (511) peut être chargée par un signal non inversé caractérisant le report, et

que les sorties des circuits ET (510 et 511) sont réunies par l'intermédiaire d'un circuit OU (513).

10. Dispositif selon la revendication 6, caractérisé en ce que le circuit de retard commandable (515) est une ligne à retard comportant des prises pour différentes valeurs de retard dans la trame temporelle étroite, et qu'il est prévu un circuit de commande multiplex (539) permettant de réaliser le choix sélectif de l'une de ces prises, conformément à la valeur somme sans report pour le premier additionneur.

11. Dispositif selon la revendication 6, caractérisé en ce que le circuit de retard commandable (515) est constitué par le branchement en série d'une première ligne à retard (103) et d'une seconde ligne à retard (104), comportant respectivement des prises pour des valeurs de retard différentes,

que l'échelonnement de temps fourni par la première ligne à retard (103) est supérieur au retard global de la seconde ligne à retard (104), et que la valeur somme sans report pour le premier additionneur est subdivisée en deux valeurs de commande pour les deux circuits de commande multiplex (102 et 105).

FIG.1

QUARZ–OSZILLATOR
100 MHZ
BASIS–FREQUENZ
(10 ns–ZEITRASTER)

10 nsec

521

GENERATOR ZUR
ERZEUGUNG DER GROB–
IMPULSINTERVALLE TOn IM
10 ns–GROB–ZEITRASTER
UND VON GROB–IMPULS–
INTERVALL–KORREKTUR–
WERTEN KTOn IM
100 ps–FEIN–ZEITRASTER

(FIG. 7)

TOn IM 10 ns–GROB–ZEITRASTER

(FIG. 6E)                    538

KTOn KORREKTURWERTE IM
100 ps–FEIN–ZEITRASTER)

(FIG. 6F)                    537

GENERATOR ZUR
ERZEUGUNG DER
SOLL–IMPULSE IM
100 ps–FEIN–ZEITRASTER
INNERHALB DER
GROB–IMPULS–
INTERVALLE TOn IM
10 ns–GROB–ZEITRASTER

(FIG. 4, 5)

GEDACHTES
GROB–IMPULSINTERVALL

SOLL–IMPULS

100 ps

536

FIG.2C

FIG.2A

FIG.2B

FIG.2D

WEG II

WEG I

10  20  30  40  50  60  70  ns

4 ns

3 ns

10 ns

4 ns

10  50  100  120  ns

1A

2A

3A

IV1 = 124 ns

IV2 = 139 ns

IM1

IM2

I1A = 44 ns

I1E = 75 ns

I2A = 73 ns

I2E = 119 ns

0 128 228

FIG. 3

QUARZ-OSZILLATOR 100 MHZ BASIS-FREQUENZ (10 ns-ZEITRASTER) — 301

WERTE ZUR VER-ZÖGERUNG DES BASIS-FREQUENZ-ZEITRASTERS — 401

SCHALTUNG ZUR ERZEUGUNG DER ANFANG UND ENDE DER IMPULSINTER-VALLE (IM 1 ns ZEIT-RASTER) KENN-ZEICHNENDEN MAR-KIERUNGSPULSE — 400

WERTE ZUR VER-ZÖGERUNG DES BASIS-FREQUENZ-ZEITRASTERS — 402

WEG I — 305
IMPULSERZEUGUNG (ZÄHLERGESTEUERT FÜR 10 ns GROB-ZEITRASTER UND VERZÖGERUNGS-GESTEUERT FÜR 1 ns FEIN-ZEIT RASTER)

WEG II — 309
IMPULSERZEUGUNG (ZÄHLERGESTEUERT FÜR 10 ns GROB-ZEITRASTER UND VERZÖGERUNGS-GESTEUERT FÜR 1 ns FEIN-ZEIT RASTER)

ZWEI-WEG JUSTAGE — 310

302 — V
307 — V
303 — &
308 — &
304 — FF
306 — FF

IV1 = 124 ns
IV2 = 139 ns
10 ns

IV1 + IV2
IV2 + IV3

IM1 / IV1
IM2 / IV2

FIG. 2C
FIG. 2A
4 ns

t →

FIG. 4

QUARZ–OSZILLATOR
100 MHZ BASIS–FREQUENZ
(10 ns–ZEITRASTER)

521

(KEIN ÜBERTRAG)

402

401

SCHALTUNG ZUR ERZEUGUNG DER GROB–IMPULSE IOn IM 10 ns–GROB–ZEITRASTER GEMÄSS FIG. 6E

(SIEHE AUCH FIG. 5, TEIL A)

ÜBERSPRINGEN EINES 10 ns–ZEITRASTERS DER BASIS–FREQUENZ BEIM AUFTRETEN EINES ÜBERTRAGS

(SIEHE AUCH FIG. 5, TEIL B UND FIG. 8)

515

PROGRAMMIERBARE VERZÖGERUNG MIT 100 ps–ZEITRASTER-STAFFELUNG (FIG. 9)

In (FIG. 6D)

535

TOn SIGNALE ZUR KENNZEICHNUNG DES BEGINNS DER GROB–IMPULS–INTERVALLE IM 10 ns–GROB–ZEITRASTER GEMÄSS FIG. 6E (n = 1, 2, 3 . . .)

(VON FIG. 7)

538

IOn (FIG. 6G)

522

&

514

534

539

ÜBERTRAG

C

ADDITIONSERGEBNIS OHNE ÜBERTRAG ZUR SELEKTIER-TEN ZEITVERZÖGERUNG TD GEMÄSS FIG. 6J

KTOn KORREKTURWERT (n = 1, 2, 3 . . .) IM 100 ps–FEIN–ZEITRASTER GEMÄSS FIG. 6F

537

(VON FIG. 7)

ADD.

508

519

501

ANFANG UND ENDE DER DIE IMPULSE IOn IM 10 ns–GROB–ZEITRASTER KENNZEICHNENDEN WERTE (FIG. 6G)

501-1

KORREKTURWERTE KIOn IM 100 ps–FEIN–ZEIT–RASTER GEMÄSS FIG. 6 H FÜR DIE IMPULSE IO IM 10 ns–GROB–ZEITRASTER

501-2

FIG. 5

SOLL—IMPULSINTERVALLE — Tn — 56,4 ns — 56,4 ns — 47,3 ns — **FIG.6A**

T1 — T2 — T3

GROB—SOLL—IMPULSINTERVALLE TnG IM 10 ns GROB—ZEITRASTER — TnG — 50 ns — 50 ns — 40 ns — **FIG.6B**

T1G — T2G — T3G

GROB—SOLL—IMPULSINTERVALL—KORREKTURWERTE KTnG IM 100 ps—FEIN—ZEITRASTER — **FIG.6C**

KT1G = 6,4 ns — KT2G = 6,4 ns — KT3G = 7,3 ns

I3E = 42,5 ns
I3A = 30,7 ns
I1E = 41,6 ns — I2E = 73,7 ns
I1A = 16,7 ns — I2A = 33,5 ns

SOLL—IMPULSE — In — I1 — I2 — I3 — **FIG.6D**

I1AT = 16,7 ns — I2AT = 39,9 ns
I1ET = 41,6 ns — I2ET = 80,1 ns

GROB—IMPULSINTERVALLE TOn IM 10 ns—GROB—ZEITRASTER — TOn — 50 ns — 60 ns — 50 ns — **FIG.6E**

TO1 — TO2 — TO3

GROB—IMPULSINTERVALL—KORREKTURWERTE IM 100 ps—FEIN—ZEITRASTER — KTOn — **FIG.6F**

KTO1 = 0 — KTO2 = 6,4 ns — KTO3 = 2,8 ns — KTO4 = 0,1 ns

IO3E = 40 ns
IO3A = 30 ns
(IOnA/IOnE) — IO1E = 40 ns — IO2E = 70 ns
IO1A = 10 ns — IO2A = 30 ns

GROB—IMPULSE IOn IM 10 ns—GROB—ZEITRASTER (AUS In MIT TOn BEZUG) — IOn — IO1 — IO2 — IO3 — **FIG.6G**

GROB—IMPULS—KORREKTUR—WERTE KIOA/En IM 100 ps—FEIN—ZEITRASTER — KIOn — [ns] — **FIG.6H**

| KIO1A = 6,7 | KIO1E = 1,6 | KIO2A = 3,5 | KIO2B = 3,7 | KIO3A = 0,7 | KIO4B = 2,5 |

SUMMENKORREKTURWERT SKnA/E — KTOn + KIOn — [ns] — **FIG.6I**

| SK1A = 0+6,7 | SK1E = 0+1,6 | SK2A = 6,4+3,5 | SK2E = 6,4+3,7 (= 10,1) | SK3A = 2,8+0,7 | SK3E = 2,8+2,5 |

SELEKTIERTE ZEITVER—ZÖGERUNG TDnA/E — TDnA/E — [ns] — **FIG.6J**

| TD1A = 6,7 | TD1E = 1,6 | TD2A = 9,9 | TD2E = 0,1 | TD3A = 3,5 | TD3E = 5,3 |

TOn KORREKTUR BEI ÜBERTRAG — **FIG.6K**

| NEIN | NEIN | NEIN | JA(10 ns) | NEIN | NEIN |

(n = 1, 2, 3 ...)

ZÄHLIMPULSE

TOn SIGNALE ZUR KENNZEICHNUNG
DES BEGINNS DER GROB–
IMPULSINTERVALLE IM
10 ns–GROB–ZEITRASTER
GEMÄSS FIG. 6E
(n = 1, 2, 3 . . . )

538

ABWÄRTS–ZÄHLER 702

DETEKTOR FÜR ZÄHLSTAND NULL 704

SCHALTUNG ZUR VERZÖGERUNG DES ZÄHLTAKTES FÜR DEN ABWÄRTS–ZÄHLER UM EINEN ZÄHLWERT BEIM AUFTRETEN EINES ÜBERTRAGES 705

PULS–GENE–RIERUNG 310

(NACH FIG. 4 BZW. FIG. 5)

LADESIGNAL 710

(TAKT) 708

ÜBERTRAG

REG. KTnG

ADD. 712

ADDITIONSERGEBNIS OHNE
ÜBERTRAG ALS
KTOn–KORREKTURWERT
(n = 1, 2, 3 . . . ) IM
100 ps–FEIN–ZEITRASTER
GEMÄSS FIG. 6F

537

LADEWERT

REG. 709

711

(NACH FIG. 4 BZW. FIG. 5)

706

707

FIG. 7

TnG | KTnG

PROZESSORGESTEUERTER SPEICHER ZUR VORGABE DER WERTE FÜR DIE ZEITDAUER DER GROB–SOLL–IMPULSINTERVALLE TnG IM 10 ns–GROB–ZEITRASTER GEMÄSS FIG. 6B UND DER KORREKTURWERTE KTnG DAFÜR IM 100 ps–FEIN–ZEITRASTER GEMÄSS FIG. 6C (n = 1, 2, 3 . . .) 701–1

35

0 128 228

SCHIEBE-
IMPULSE ⌐ 521
S1
S2
S3
D
522
509

# FIG.8

ZEITPUNKT DES AUFTRETENS
EINES ERSTEN SIGNALS AUF
522 LEITUNG 522

START 10n 10n

100 MHZ
SCHIEBE-
IMPULSE →t

SCHIEBEREGISTER-STUFENMARKIERUNG

S1 →t

S2 →t

S3 →t

(VON FIG. 5) 534 515

D1
VER-
ZÖGE-
RUNGS-
LEITUNG D2
D3
MULTI-
PLEX-
SCHAL-
TUNG
(NACH FIG. 5)
535

D98
D99

515-1 515-2 539

(VON FIG. 5)

# FIG.9

515-10

104

103    102    105

534,

| VER— |  | 1 |  |  |  | 00 ps |  |  |  |
| ZÖGERGS— |  | 2 | M P X |  |  | 10 ps | M P X |  |  |

VER—
ZÖGERGS—
LEITUNG
MIT UM
JEWEILS
100 ps
GESTAF—
FELTEN
AB—
GRIFFEN

M P X

00 ps
10 ps
20 ps
30 ps

M P X

535

99

80 ps
90 ps

100

ADDITIONSERGEBNIS
FÜR DEN BEREICH
0, 100, 200, 300, . . . 9900 ps

101

ÜBERTRAG

C

ADD.

ADDITIONSERGEBNIS FÜR DEN BEREICH
0, 10, 20, . . . 90 ps OHNE ÜBERTRAG

508 – 10

FIG. 10